# EUROPEAN PATENT SPECIFICATION

(11) **EP 3 474 281 B1**
(45) Date of publication and mention of the grant of the patent: **22.12.2021**
(21) Application number: 17197856.2
(22) Date of filing: 23.10.2017
(51) Int. Cl.: G11C 11/16, G11C 13/06

(54) **ANTIFERROMAGNETIC MEMORY**
ANTIFERROMAGNETISCHER SPEICHER
MÉMOIRE ANTIFERROMAGNÉTIQUE

(43) Date of publication of application: 24.04.2019
(73) Proprietor: Hitachi, Ltd., Tokyo (JP); Institute of Physics ASCR v. v. i., 162 00 Praha 6 (CZ); University of Nottingham, Nottingham NG7 2RD (GB)
(72) Inventor: Wunderlich, Joerg, Cambridge, Cambridgeshire CB3 0HE (GB); Jungwirth, Tomas, 162 00 Praha 6 (CZ); Olejnik, Kamil, 162 00 Praha 6 (CZ); Zelezny, Jakub, 162 00 Praha 6 (CZ); Novak, Vit, 162 00 Praha 6 (CZ); Godinho, Joao, 162 00 Praha 6 (CZ); Janda, Tomas, 162 00 Praha 6 (CZ); Roy, Pierre, Cambridge, Cambridgeshire CB3 0HE (GB); Otxoa, Rubén, Cambridge, Cambridgeshire CB3 0HE (GB); Wadley, Peter, Nottingham, NG7 2RD (GB); Edmonds, Kevin, Nottingham, NG7 2RD (GB); Gallagher, Bryan, Nottingham, NG7 2RD (GB); Campion, Richard, Nottingham, NG7 2RD (GB)
(74) Representative: Piotrowicz, Pawel Jan Andrzej

(56) References cited:
- EP-A1- 3 001 470
- WO-A2-2015/072856
- US-A1- 2009 175 110
- K. OLEJNÍK ET AL: "Antiferromagnetic CuMnAs multi-level memory cell with microelectronic compatibility", NATURE COMMUNICATIONS, vol. 8, 19 May 2017 (2017-05-19), pages 1-13, XP55468054, DOI: 10.1038/ncomms15434
- SANDER D ET AL: "The 2017 Magnetism Roadmap", JOURNAL OF PHYSICS D: APPLIED PHYSICS, INSTITUTE OF PHYSICS PUBLISHING LTD, GB, vol. 50, no. 36, 18 August 2017 (2017-08-18), page 363001, XP020319470, ISSN: 0022-3727, DOI: 10.1088/1361-6463/AA81A1 [retrieved on 2017-08-18]
- J Zelezný ET AL: "Spin-transport, spin-torque and memory in antiferromagnetic devices: Part of a collection of reviews on antiferromagnetic spintronics", , 30 May 2017 (2017-05-30), XP055468320, Retrieved from the Internet: URL:https://arxiv.org/ftp/arxiv/papers/170 5/1705.10675.pdf [retrieved on 2018-04-18]
- M.J. GRZYBOWSKI ET AL: "Imaging Current-Induced Switching of Antiferromagnetic Domains in CuMnAs", PHYSICAL REVIEW LETTERS, vol. 118, no. 5, 3 February 2017 (2017-02-03), pages 1-5, XP055468559, US ISSN: 0031-9007, DOI: 10.1103/PhysRevLett.118.057701

## Description

### Field of the Invention

The present invention relates to a method of operating an antiferromagnetic memory, ***i.e.*** a memory in which an antiferromagnetic region stores data, in particular to a method of programming an antiferromagnetic memory.

### Background

Current information technologies are either based on charge or spin of charge carriers, such as electrons, employing semiconductor devices whose electronic states can be easily manipulated and detected.

One drawback of existing devices is that perturbations, such as high-energy radiation, can cause charge redistribution and data loss. Moreover, development of charge-based devices is approaching its limits. The International Technology Roadmap for Semiconductors, which is driven by so-called "Moore's law", is now reaching its end.

Spintronic devices are considered as alternatives to charge-based devices. Spintronics is an active, rapidly-developing field drawing on relativistic quantum physics, materials science and nanoelectronics. Spintronic devices can use all the fundamental properties of charge carriers including not only charge and mass, but also spin. While the charge and mass have respective single values, additionally using spin can provide synergistic benefits since spin is a vector which can provide additional phenomena and functionalities.

Existing commercially-available spin-based devices rely on using two opposite magnetisation orientations in a ferromagnet to represent logical 'o' and logical '1'. These spin-based devices include magnetic hard-disk drives and magnetic random-access memories. Since these devices are based on ordered states of spin, they are inherently non-volatile and resistant to charge perturbations.

Until now, spin-based memory devices have relied on ferromagnets to provide functional units for information storage. Recently, however, attention has been given to realizing memory devices based on antiferromagnets in which spin direction periodically alternate from one atomic lattice site to the next. Hitherto, antiferromagnets only played a passive role in spintronic devices by stabilizing magnetic orientation in a reference magnet via interlayer exchange coupling or by reducing any net stray magnetic field generated by individual ferromagnetic elements when arranging them into antiferromagnetic order in so called "synthetic antiferromagnets".

Ferromagnets are, however, limited in terms of the size to which they can be scaled down and operating speed. Operating speed is limited to the gigahertz frequencies by the fastest-possible Larmor precession around a relatively-weak anisotropy field or a comparably weak external magnetic field. Packing density is limited due to the magnetic stray-fields generated by individual ferromagnetic elements. Unintentional weak magnetic fields can perturb information stored in ferromagnetic elements. The task of improving performance has recently led to a growing interest in alternative magnetically-ordered systems, such as antiferromagnets. Reference is made to T. Jungwirth et al.: "Antiferromagnetic spintronics", Nature Nanotechnology, volume 11, page 231 (2016).

Although there are benefits to using antiferromagnets, there is, however, a significant obstacle discouraging their use. Reorienting spins in antiferromagnets with comparable efficiency to ferromagnets requires fields compatible with the staggered Neel-order of magnetic moments in antiferromagnets. A uniform magnetic field favours parallel alignment of the moments and is employed routinely to reorient moments in ferromagnets. In antiferromagnets, a uniform magnetic field acts against the staggered internal exchange field, which diminishes coupling of the magnetic field to the Neel magnetic order. Strong coupling can be achieved if the sign (i.e. direction) of an externally-generated field alternates on the scale of a lattice constant at which moments alternate in antiferromagnets. Only such local fields can efficiently control the alternating atomic spins in antiferromagnets. However, generation such a field has been regarded as being unfeasible, thereby hindering application of this type of magnetically-ordered materials.

P. E. Roy et al.: "Robust picosecond writing of a layered antiferromagnet by staggered spin-orbit fields", Physical Review B volume 94, page 014439 (2016) is a theoretical study which proposes ultrafast electrical switching by current-induced staggered spin-orbit fields.

Olejnik, K. et al.: "Antiferromagnetic CuMnAs multi-level memory cell with microelectronic compatibility", Nature Communications, vol. 8, page 15434 (2017) discloses elementary-shape memory cells fabricated from a single-layer antiferromagnet CuMnAs deposited on a III-V or Si substrate having deterministic multi-level switching characteristics. They allow for counting and recording thousands of input pulses and responding to pulses of lengths downscaled to hundreds of picoseconds. To demonstrate the compatibility with common microelectronic circuitry, the antiferromagnetic bit cell was implemented in a standard printed circuit board managed and powered at ambient conditions by a computer via a USB interface.

Sander, D. et al.: "The 2017 Magnetism Roadmap", Journal of Physics D: Applied Physics, vol. 50, page 363001 (2017) discloses multiple contributions addressing the questions of atomic scale confinement, 2D, curved and topological magnetic materials, as well as materials exhibiting unconventional magnetic phase transitions, as well as contributions devoted to advances in magnetic characterization, magneto-optics and magneto-plasmonics, ultrafast magnetization dynamics and magnonic transport. Other contributions present non-volatile memory technology, antiferromagnetic spintronics, as well as magnet technology for energy and bio-related applications.

Zelezny, J. et al.: "Spin-transport, spin-torque and memory in antiferromagnetic devices: Part of a collection of reviews on antiferromagnetic spintronics", arXiv:1705.10675 (2017) describes the recent progress in electronic spin-transport and spin-torque phenomena in antiferromagnets that are dominantly of the relativistic quantum mechanics origin. Also discussed are their utility in pure antiferromagnetic or hybrid ferromagnetic/antiferromagnetic memory devices.

US 2009/175110 A1 discloses a very small magnetic tunnel junction formed on a semiconductor p-i-n diode. Spin-polarized current which is generated by circular polarized light or elliptically-polarized light, is injected into a free layer of the magnetic tunnel junction so that magnetization direction (two opposite directions) in the free layer is changed based on the information, whereby information is stored in the memory element.

EP 3001470 A1 discloses an antiferromagnetic memory device. The memory device comprises an antiferromagnetic region having a broken inversion symmetry along an axis, for example, by virtue of having bulk broken inversion symmetry in part of the unit cell corresponding to the antiferromagnetic spin sublattice or in the full unit cell or by virtue of being sufficiently thin and having broken structural inversion symmetry. The antiferromagnetic region may comprise di-manganese gold (Mn2Au). The antiferromagnetic region has an antiferromagnetic spin axis which is selectively orientable along first and second easy axes which are not parallel to the axis along which inversion symmetry is broken. The memory device also comprises a conductive channel configured to define a conductive path through the antiferromagnetic region which is substantially not parallel to the axis along which inversion symmetry is broken or the device comprises a conductive path through a paramagnetic or diamagnetic region adjacent to the antiferromagnetic region so as to cause spin-polarised current to diffuse into the antiferromagnetic region.

Grzybowski, M. J. et al.: "Imaging Current-Induced Switching of Antiferromagnetic Domains in CuMnAs", Physical Review Letters, vol. 118, pages 1 to 5 (2017) discloses, using x-ray magnetic linear dichroism microscopy, that staggered effective fields generated by electrical current can induce modification of the antiferromagnetic domain structure in microdevices fabricated from a tetragonal CuMnAs thin film. A clear correlation between the average domain orientation and the anisotropy of the electrical resistance is demonstrated, with both showing reproducible switching in response to orthogonally applied current pulses. However, the behavior is inhomogeneous at the submicron level, highlighting the complex nature of the switching process in multidomain antiferromagnetic films.

### Summary

The present invention is set out in independent claims 1, 3 and 15. Preferred aspects are defined in dependent claims 2 and 4-14. According to a first aspect of the present invention there is provided a method comprising generating at least one current pulse in an antiferromagnetic region of an antiferromagnetic memory device, the antiferromagnetic region consisting of an antiferromagnetic material exhibiting inversion asymmetry of spin-sublattices, wherein a portion of the or each current pulse (i.e. the part of a pulse which tends to be a positive or negative section of the pulse between zero crossing which has the maximum amplitude) has a duration less than 250 ps and a magnitude which is sufficiently high such that an electric field strength of at least 10⁵ V cm⁻¹ is generated in the antiferromagnetic region to induce staggered spin-orbit fields in the antiferromagnetic region so as to switch magnetic moments in at least a portion of the antiferromagnetic region, wherein the portion of the or each current pulse causes the switching of the magnetic moments. Generating the at least one pulse comprises exposing the antiferromagnetic region to at least one gigahertz or terahertz pulse (*e.g.* ≥ 100 GHz) of electromagnetic radiation which is elliptically or linearly polarized.

According to a second aspect of the present invention there is provided a method comprising generating at least one current pulse in an antiferromagnetic region of an antiferromagnetic memory device which is in electrical contact with or forms part of a photocarrier generator, the antiferromagnetic region consisting of an antiferromagnetic material exhibiting inversion asymmetry of spin-sublattices, wherein the current pulse has a duration less than 250 ps and a magnitude which is sufficiently high such that an electric field strength of at least 10⁵ V cm⁻¹ is generated in the antiferromagnetic region so as to induce a staggered spin-orbit field strong enough to switch magnetic moments in at least a portion of the antiferromagnetic region. Generating the at least one pulse comprises exposing the photocarrier generator to at least one optical pulse, the or each pulse having a duration less than 250 ps.

### Brief Description of the Drawings

Certain embodiments of the present invention will now be described, by way of example, with reference to the accompanying drawings, in which:
Figure 1a illustrates a first antiferromagnetic memory device comprising a cross-shaped layer of antiferromagnetic material and writing first and second states using THz electric field transients having first and second orthogonal linear polarizations respectively;
Figure 1b illustrates a second antiferromagnetic memory device comprising a p-i-n-diode and a layer of antiferromagnetic material on the p-i-n diode and writing first and second states using a 100-fs laser pulse while the diode is reversed biases and connecting first and second orthogonal current paths to ground;
Figure 1c illustrates a third antiferromagnetic memory device comprising a photoconductive Auston switch type device embedded in a co-planar waveguide which is part of an antiferromagnetic cross bar device;
Figure 2a schematically illustrates the crystal and magnetic structure of CuMnAs and shows, in the presence of an electrical current, generation of staggered spin-orbit fields that switch antiferromagnetic moments;
Figure 2b shows reversible writing of a first antiferromagnetic memory device by electrical pulses of two orthogonal current directions delivered via wire-bonded contacts;
Figure 2c illustrates a waveform of an applied microsecond electrical pulse;
Figure 2d shows THz electric field transients whose linear polarization can be chosen along two orthogonal directions;
Figure 2e illustrates a wave form of an applied picosecond electrical pulse
Figure 3a illustrates reversible multi-level switching using microsecond electrical pulses;
Figure 3b illustrates reversible multi-level switching multi-level switching using picosecond electrical pulses;
Figure 4a illustrates a multi-level memory signal as a function of number of applied picosecond pulses;
Figure 4b illustrates a multi-level memory signal as a function of number of applied microsecond pulses;
Figure 5a illustrates, in a main panel, magnitude of switching signal as a function of the THz field amplitude, in the inset, of the converted current density for 1, 2 and 3 µm size devices and, in the top panel, electron micrographs of 1 and 3 µm size devices;
Figure 5b shows writing energy density required to obtain a 1 mΩ change in transverse resistance signal after switching as a function of the writing speed 1/*τₚ* using a linear scale (main plot) and in a log-log scale (inset) for 2, 3 and 4 µm size devices, wherein black star-symbols and dashed line represent the limiting breakdown energy density;
Figure 5c illustrates contact writing using 200 ms pulses of current density 1×10⁷ Acm-2 (white intervals) and the contact writing superimposed on the non-contact writing by a train of picosecond pulses with a kHz repetition rate and a THz field amplitude corresponding to an additional current density of approximately 1.6 × 10⁹ Acm⁻² (grey intervals), measured in a 10 µm-size CuMnAs/Si bit cell;
Figure 6a illustrates rectifying behaviour of a p-i-n diode in the dark;
Figure 6b is a micrograph of a variant of the second antiferromagnetic device having an annular top electrode;
Figure 6c schematically illustrates current line direction and staggered spin-orbit field;
Figure 7 illustrates reading an antiferromagnetic memory device by identifying the Néel vector L in a four-terminal device;
Figure 8a illustrates reading an antiferromagnetic memory device by identifying the Neel vector L in a two-terminal device;
Figure 8b schematically illustrates current polarity dependent switching in a device where the easy axis and current direction are rotated by 45°;
Figure 9a illustrates read-out by optically determining the Néel vector in a thin-film antiferromagnet with uniaxial magneto-crystalline anisotropy by time resolved pump-magnetic linear dichroism (MLD) probe measurement;
Figure 9b is illustrates that strong pump laser pulse-induced local heating of a sample leads to a demagnetization and, consequently, to a reduction of a probe polarization rotation; and
Figure 9c illustrates time resolved pump-induced change of MO signal measured by probe pulses with different ε in transmission geometry;
Figure 10a illustrates a current pulse profile with a dominantly positive amplitude part;
Figure 10b illustrates a current pulse profile with a dominantly negative amplitude part;
Figure 11 is a photoemission electron microscopy (PEEM) x-ray magnetic linear dichroism (XMLD) micrograph of an antiferromagnetic region with uniaxial magnetic anisotropy. The dark lines are corresponding to 180deg domain walls;
Figure 12 illustrates switching by domain wall movement in a bar-shaped antiferromagnetic device with uniaxial anisotropy and easy axis perpendicular to the bar;
Figure 13 illustrates read-out using second harmonic transverse anisotropy magnetoresistance measurement;
Figure 14 illustrates read-out of a cross-shaped antiferromagnetic device and shows second harmonic resistance measurements obtained for four different Néel vector configurations;
Figure 15 illustrates first and second arrangements required to distinguish four different Néel vector configurations in a cross-shaped antiferromagnetic device;
Figure 16 shows second harmonic resistance measurements for two 180° reversed Néel vector states as a function of time and illustrates non-volatile memory functionality in a cross-shaped antiferromagnetic device;
Figure 17 illustrates linear increase of second harmonic resistance signal against probing current amplitude;
Figure 18 illustrates a modified bar-shaped device having a section configured to nucleate a domain;
Figure 19 is a plot of domain wall velocity against spin-orbit field;
Figure 20a illustrates four possible configurations, relative to the applied current direction, of an antiferromagnetic 90° domain wall in the *ab* plane of tetragonal CuMnAs;
Figure 20b is an optical micrograph of a CuMnAs cross-shaped device;
Figure 20c is an x-ray image of antiferromagnetic domain structure observed using x-rays with linear polarization along the [1-10] crystal axis;
Figure 20d is an x-ray image of antiferromagnetic domain structure observed using PEEM x-rays magnetic linear dichroism (XMLD) measurement with x-ray linear polarization along the [100] crystal axis;
Figures 21a and 21b are XMLD PEEM images of an antiferromagnetic domain structure located along one of the arms of the CuMnAs cross-shaped device obtained with x-ray polarization parallel to the [1-10] axis before and after applying current pulses;
Figures 21c and 21d x are XMLD-PEEM images of an antiferromagnetic domain structure located along one of the arms of the CuMnAs cross-shaped device obtained with x-ray polarization parallel to the [100] axis before and after applying current pulses;
Figures 21e and 21f show the difference between Figures 21a and 21b between Figures 21c and 21d respectively;
Figure 21g shows a series of XMLD-PEEM images of an antiferromagnetic domain structure located along one of the arms of the CuMnAs cross-shaped device obtained with x-ray polarization parallel to the [1-10] axis before and after applying current pulses of alternating polarity showing a series of reversals;
Figure 21h shows dependence of average change in signal on the amplitude of the current pulse, for a fixed pulse duration of 2.5 ms;
Figure 22 shows a cross-shaped device, 180° switching and a measurement at 20;
Figure 23 shows a cross-shaped device, 90° switching by using four bars to transmit diagonal pulses, and a measurement at ω;
Figure 24 shows a cross-shaped device, 90° switching using four bars to transmit diagonal pulses and a measurement at ω;
Figure 25 shows a cross-shaped, hayfork-ended device, 180° and 90° switching and plots of the magnetoresistance as a function of probing current amplitude at ω enabling readout of 90° switching and at 2ω enabling additionally readout of 180° switching;
Figures 26a and 26b illustrate long retention time for 180° switching and shorter retention time for 90° switching, both 90° switching and 180° switching are performed at room temperature, in the same cross bar device and the same switching pulse current density;
Figure 26c illustrates long retention time of at least more than 2 hours for 180° switching;
Figure 27 illustrates a cross-shaped device having a fifth electrode and a tunnel barrier layer arranged for tunnelling anisotropy magnetoresistance (TAMR) read-out;
Figure 28 is a schematic block diagram of memory including an array of memory cells, each cell including an antiferromagnetic memory device; and
Figure 29 illustrates a cell used in the memory shown in Figure 28.

### Detailed Description of Certain Embodiments

### Introduction

Three different types of antiferromagnetic memories are described herein that are based on switching antiferromagnets using current-induced staggered effective spin-orbit fields. Herein, an antiferromagnetic memory is one in which an antiferromagnetic region stores data, as opposed to, for example, a ferromagnetic memory in which a ferromagnetic region stores data, but which includes an antiferromagnetic region that is used to help pin a ferromagnetic reference layer.

As will be explained in more detail hereinafter, the speed of reversible electrical writing in the memories can be scaled up to the terahertz frequencies, while the energy need to write at such frequencies is comparable with those writing at gigahertz frequencies. The writing speed in the antiferromagnetic memories herein described can exceed those of ferromagnetic memories by several orders of magnitude.

The antiferromagnetic memories are generally based on ultrafast electrical writing schemes involving external sources of THz-field transients or built-in photoconductive switches. The writing schemes involve generating ultra-short current pulses having a duration of less than 250 ps, for example, about a picosecond, or even as short as 100 femtoseconds, and sufficiently large current pulse amplitudes to switch the magnetic moments in an antiferromagnetic memory cell.

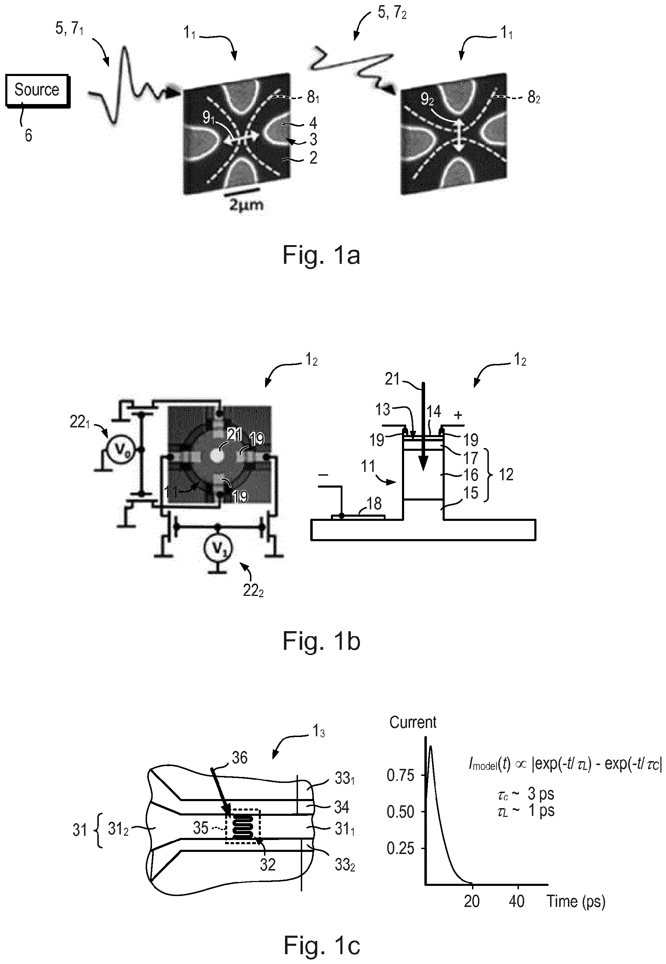

Referring to Figure 1a, a first antiferromagnetic memory device (or "cell") 1₁ is shown.

The first antiferromagnetic memory device 1₁ (herein referred to as a "crossbar memory cell") includes a cross-shaped layer 2 of an antiferromagnetic material in the form of copper manganese arsenide (CuMnAs) the shape of which is defined by lateral isolation trenches 3 and which is supported on an electrically-isolating substrate in the form of semi-insulating gallium arsenide (GaAs) or gallium phosphide (GaP) substrate 4. The antiferromagnetic layer 2 has a thickness of 5 nm, although the layer 2 may be thinner or thicker, for example having a thickness up 50 nm or even up to 100 nm.

Reversible writing of the crossbar memory cell 1₁ involves applying a terahertz electromagnetic transient 5 using a laser 6 to the crossbar memory cell 1₁ perpendicularly to the plane of the layer 2. By setting linear polarization along one of two orthogonal directions 71, 72, the direction of the path 81, 82 taken by a picosecond current pulse in the layer 2 can be set. Preferred Neel vector orientation 91, 92 corresponding to the current paths 81, 82 is shown.

Referring to Figure 1b, a second antiferromagnetic memory device (or "cell") 1₂ is shown in plan view (on the left-hand side of the figure) and schematically in side view (on the right-hand side of the figure).

The second antiferromagnetic memory device i2 comprises a pillar 11 forming a vertical p-i-n photodiode 12 having a top surface 13 supporting a thin film 13 of antiferromagnetic material. The photodiode 10 comprises a base 15 of p-type gallium arsenide, a layer 16 of intrinsic gallium arsenide having a thickness of 1 µm and a layer 17 of n-type gallium arsenide. The antiferromagnetic material takes the form of CuMnAs. Electrical contact is made via a bottom contact 18 to the p-type base 13 and via one or more of four contacts 19 made to the peripheral edge of the antiferromagnetic layer 14.

A laser (not shown) is used to expose the p-i-n junction 12 when reversed biased with sub-picosecond laser pulses 21 to generate picosecond current pulses (not shown) through the antiferromagnetic thin film 14. To match the band gap of the GaAs photodiode 12, laser pulses 21 having a wavelength in the near infrared range are used. The direction of the current pulses in the antiferromagnetic layer 14 is determined by the connection of the four top contacts 19 controlled by first and second gate biases Vo, V1 applied by voltage sources 221, 222. By grounding one or preferably two, opposite contacts 19 and leaving the other contacts floating 10, the antiferromagnetic thin film 14 may be programmed.

For the first and second antiferromagnetic memory devices 1₁, 1₂, writing involves biaxially switching between two, different preferred directions of the antiferromagnetic Neel vector and reading involves, for example, using measuring anisotropic magneto resistance (AMR) of the antiferromagnetic layer.

Referring to Figure 1c, a third antiferromagnetic memory device (or "cell") 1₃ is shown.

The third antiferromagnetic memory device 1₃ is based on a photoconductive Auston switch and comprises a two-part central strip 31₁, 31₂ of antiferromagnetic material, in this case CuMnAs having a thickness of, for example, 10 nm, separated by a serpentine gap 32 which forms two sets of interdigitated fingers. Another type of Auston switch (not shown) may be realised by a straight gap. The central strip 31₁, 31₂ is embedded in a co-planar waveguide comprising first and second strips 33₁, 33₂ of the antiferromagnetic material. The antiferromagnetic material 31₁, 31₂, 33₁, 332 is supported on a semiconductor substrate 34 in the form of low-temperature grown GaAs. The antiferromagnetic material 31₁, 31₂, 33₁, 332 may support a thin layer of metal, such as platinum, for example, having a thickness of 3 nm.

A laser (not shown) is used to expose an active region 35 i.e. around the gap 32, with sub-picosecond laser pulses 36 to generate picosecond current pulses in the semiconductor substrate 34.

Pulse rise time depends mainly on the recombination time of carriers and pulse fall time is usually determined by the Auston switch capacity.

### Ultrafast and non-volatile current polarity dependent uniaxial switching

Switching between two states with opposite Néel vectors can be realised by ultrafast current pulse induced domain wall motion of 180° antiferromagnetic domain walls. Since the two opposite states are energetically equivalent they can exhibit very long retention times. Reading is performed using homodyne AMR detection at double the frequency of an alternating current excitation, which only weakly perturbs the antiferromagnetically coupled moments, to identify the two states with opposite Néel vectors. While the first and second devices 1₁, 1₂ are four-terminal devices, the third device 1₃ is a two-terminal device. However, ultrafast switching can also occur by coherent rotation of the Néel vector of a single domain if the current direction and the easy axis are not collinear.

Another current polarity dependent ultrafast switching mechanism can be used for biaxial antiferromagnets in which a 90° domain wall moves in one direction or the opposite direction depending on the polarity of the applied current. However, ultrafast switching can also occur by coherent rotation of the Néel vector of a single domain.

### Fast switching with linearly-polarised THz pulse

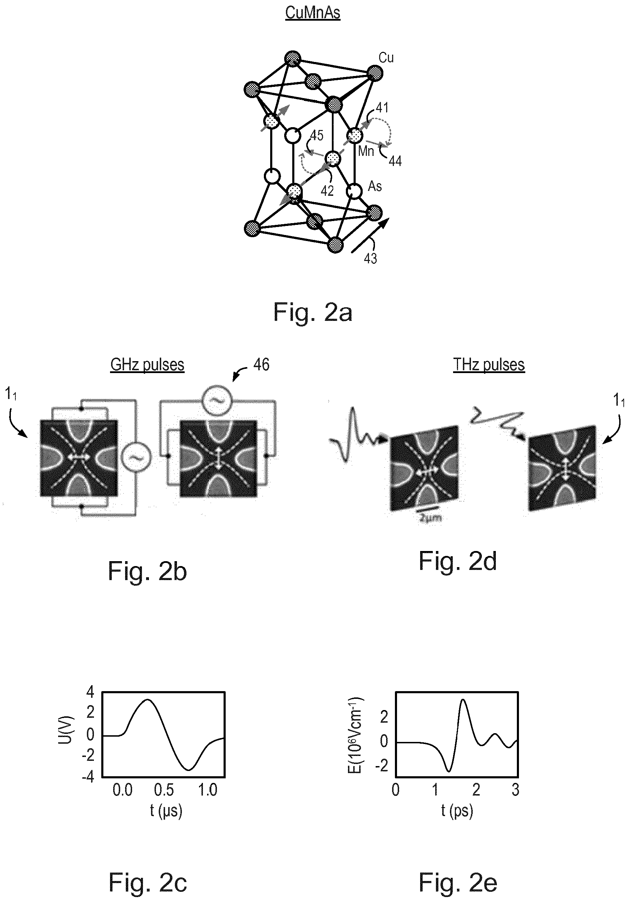

The principle of the current-driven antiferromagnetic switching is described with reference to Figure 2a.

Figure 2a shows the crystal and magnetic structure of CuMnAs which is an antiferromagnetic compound with a high Néel temperature. The manganese spin-sublattices with opposite magnetic moments 41, 42 occupy non-centrosymmetric crystal sites that are inversion partners. The local symmetry properties of the lattice together with the spin-orbit coupling imply that a global electrical current 43 driven through the crystal generates local, oppositely-oriented carrier spin-polarizations 44, 45 at the inversion partner sites, with the polarization axis perpendicular to the applied current.

The alternating non-equilibrium polarization acts as an effective staggered magnetic field on the antiferromagnetic moments. The strength of the staggered field is proportional to the current-induced polarization and to the exchange coupling between the carrier spins and the antiferromagnetic moments. The underlying physics is analogous to spin-orbit torque switching mechanism in ferromagnets, but whose writing speed is limited by the GHz ferromagnetic resonance frequency.

To establish feasibility in antiferromagnets to extend writing speeds to the THz band, ultra-short writing pulse experiments are compared to results obtained with longer writing pulses in the same device structures.

A writing pulse time *τₚ* is scaled down to 250 ps which corresponds to a writing speed 1/ *τₚ* of up to 4 GHz. In this scheme, the current pulses are delivered via wire-bonded contacts, and here *τₚ* ∼100 ps is at the achievable limit using a current-pulse setup.

Referring to Figure 2b, reversible switching is realized in a cross-shape bit cell 1₁ by alternating current pulses, using signal source 46, along one of the two orthogonal directions, shown as white dashed lines on electron micrograph. White double arrows depict the corresponding magnetic sub-lattices with magnetisations **Ma** and **Mb** forming the Néel vector **L = Ma - Mb** with orthogonal orientations preferably set by the two current directions. Apart from the reversible switching controlled by alternating the two orthogonal writing currents, multiple- pulses can be applied successively along one writing path, revealing a neuron-like multi-level bit- cell switching characteristics typical of antiferromagnets. This is associated with multidomain reconfigurations. As will be explained in more detail hereinafter, this feature can be exploited in picosecond-pulse experiments.

Referring to Figure 2c, for experiments with 1/ *τₚ* in the THz range, the same cross-shape bit cell 1₁ and an analogous experimental setup is used. However, a non-contact technique is used for generating the ultra-short current pulses in the memory cell 1₁ to overcome the limit of common current-pulse setups. To explore reversible writing with pulses of *τₚ* ∼1 ps, THz electro-magnetic transients are applied whose linear polarization can be chosen along two orthogonal directions.

Figure 2e shows a plot of the real waveform of the electric field transient. As in the contact writing scheme, white double-arrows depict the corresponding orthogonal Néel vector orientations preferentially set by the two orthogonal polarizations.

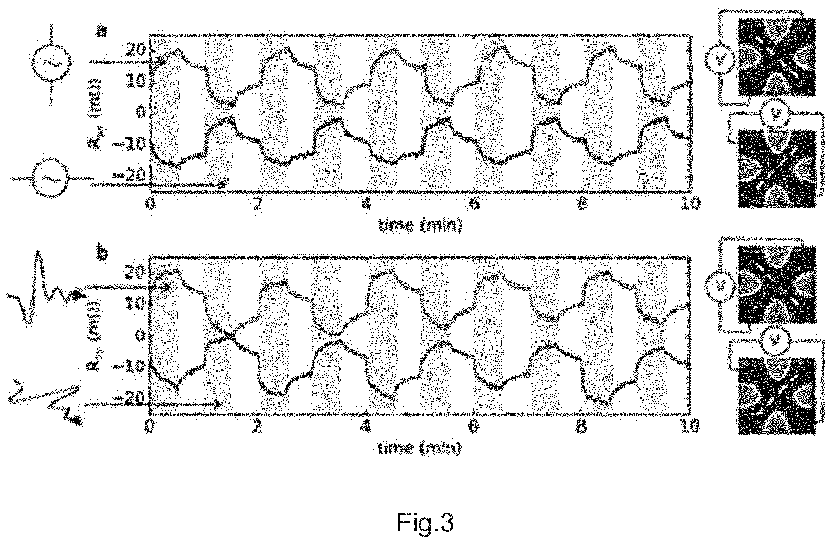

Referring to Figures 3a and 3b, in both contact and non-contact setups, the electrical readout is performed by detecting the antiferromagnetic transverse anisotropic magnetoresistance (AMR). Readout current direction is depicted by the white dashed line. The transverse AMR has an opposite sign for the two orthogonal Néel vector directions. To confirm the AMR symmetry, two detection geometries are employed in which the readout current and transverse-voltage axes are interchanged. For the AMR, the readout signal flips sign between the two geometries. It is noted that the AMR readout signal does not depend on the polarity of the switching current. In the experiments, a bipolar wave-form is applied in the contact (i.e. longer pulse-time) experiments to highlight correspondence to the non-contact (i.e. ps-pulse measurements). The experiments are performed at room temperature.

### Experimental results

Referring to Figure 3a, comparative data is presented for microsecond writing pulses delivered by the contact method in a CuMnAs/GaAs bit cell 1₁. The pulse-train of one current direction is turned on for 30 s, then the train is turned off for 30 s followed by turning on for 30 s the pulse-train with the orthogonal current direction. The data show multi-level switching of the antiferromagnet by the current-induced staggered spin-orbit field. The readout signal increases as the successive pulses within a train arrive at the bit-cell. When the pulse-train is turned on, the readout signal of the memory cell partially relaxes. It is noted that the retention stability can be broadly varied by changing the antiferromagnetic structure parameters. The sign of the signal is switched when applying the pulse-train with the orthogonal current direction and the overall sign of these reversible switching traces flips between the two readout geometries, consistent with the AMR symmetry. Data were obtained for an applied writing current density j = 3 × 10⁷ Acm⁻² and a writing pulse repetition rate of 1 Hz. The magnitude of the signal depends, apart from the number of pulses, on the magnitude of the writing current density and the pulse time.

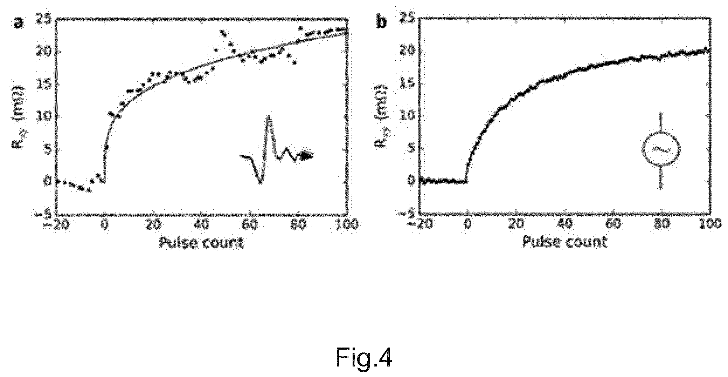

Referring to Figure 4a, remarkably similar reversible switching traces, with an initial steep increase of the AMR signal followed by a tendency to saturate, can be written in the same CuMnAs/GaAs memory cell structure using picosecond pulses in accordance with the present invention. The writing pulse repetition rate was set to 1 kHz and the current density, recalculated from the applied intensity of the THz electric field E = 1.1×10⁵ Vcm⁻¹, was increased to j ≈ 2.7×10⁹ Acm⁻² for ultra-short pulses. The correspondence between the measured data shown in Figure 3a and in Figure 3b indicates that, for the picosecond pulses, antiferromagnetic switching is also due to the current-induced staggered spin-orbit field. Note that this switching mechanism allows the electric field transient to be employed and that there is no reliance on the weak magnetic field component of the radiation or on the non-linear orbital-transition effects.

To resolve the change in the AMR readout signal induced by a single picosecond pulse, the current density was increased to j ≈ 2.9 × 10⁹ Acm⁻² and the repetition rate of the writing pulses reduced to 125 Hz and matched it closely to the readout repetition rate (100 Hz).

Referring to Figures 4a and 4b, measured data are plotted as a function of the pulse number. It is observed that the initial picosecond pulse accounts for a sizable portion of the total signal generated by the pulse-train. Note that the scatter in the measured data is likely of an instrumental origin due to the electrical noise from the laser setup. In Figure 4b, corresponding measurements with the microsecond pulses highlights the analogous phenomenology of the THz-speed writing and the slower writing in the multi-level antiferromagnetic bit cell.

Referring again to Figure 2e, the electrical current density generated in the cells for a given amplitude of the picosecond electric-field pulse could not be directly measured. Following a simple approach, according to the Ohm's law, incident THz field can be divided by the resistivity of CuMnAs resistivity. This would result in a device-geometry independent current density of j = 8 × 10⁸ Acm⁻² per peak THz field of 105 Vcm⁻¹. This, however, is overly simplistic.

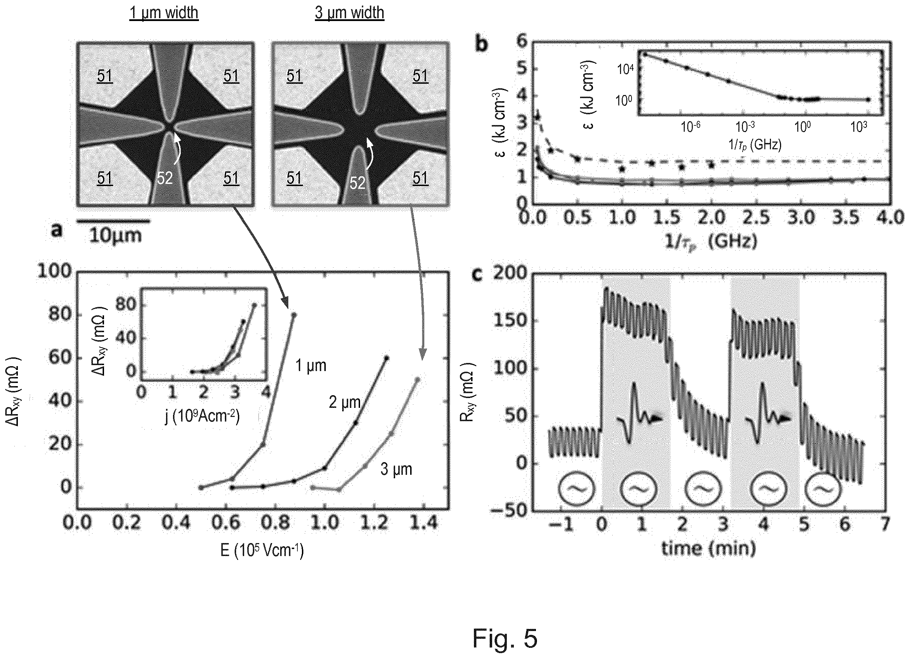

Referring to Figures 5a to 5c, when plotting the THz-induced switching signal as a function of the incident THz peak field, it can be seen that three devices having the same geometry of gold contact pads 51 but having different widths of central cross 52, namely 1, 2, and 3 µm respectively, exhibit different dependencies, but approximately the same resistance.

This observation is ascribed to the gold electrodes 51 which strongly modify the incident THz field in the cross region 52. A THz field polarized parallel to an electrode drives currents inside the metal, thereby inducing charges of opposite sign on opposite electrode apexes. These charges and the resulting voltage across the inner device, govern the current in the CuMnAs crosses 52. At a given incident THz peak field, the current flowing through the three crosses is comparable and, correspondingly, the current density scales up with decreasing width of the crosses. This is consistent with the observation of increasing AMR signal with decreasing cross size, as shown in the main plot of Figure 5a. Indeed, when the data of the main plot of Figure 3a is re-scaled by the cross sizes, as shown in the inset of Figure 5a, the three curves fall on top of each other, in agreement with the expected phenomenology for the current-induced spin-torque switching.

It is noted that charges at the electrode apexes are induced also when a voltage is applied between opposite electrodes in the contact experiments. Therefore, similar field distributions in the cross region are expected for the contact (Figure 2b) and non-contact (Figure 2c) field applications, differing only by a global scaling factor. Advantage is taken of this notion to quantitatively calibrate the THz current. As explained in more detail hereinafter, in the contact experiments, the critical absorbed Joule energy density leading to device damage for 1/*τₚ* up to 4 GHz is determined. Since the energy already saturates in the GHz range, extrapolation to the THz writing speed is straightforward and enables determination of the scaling factor between the incident peak field and the resulting peak current density in the CuMnAs cross.

The calibration procedure allows plotting of the characteristic Joule energy density ε required to obtain a reference switching signal of, *e.g.,* 1Ω, up to the THz range, as shown in the inset of Figure 5b. The Joule energy density ε steeply decreases with increasing 1/ *τₚ* below -MHz to a saturated value of ε in the GHz range (see also main plot of Figure 5b) that extends to the THz writing speed. This demonstrates that current-induced switching at the THz writing speed is as energy-efficient as at the GHz speed

The Joule energy leading to device damage and the energy required for the reference 1 Ω switching signal are separated by approximately a factor of 2 in both the GHz and THz writing-speed range. This breakdown margin is sufficiently large, allowing tens of thousands of reversible write-read cycles to be demonstrated without any notable device wear-out.

Referring to Figure 5c, an antiferromagnetic multi-level bit-cell can be simultaneously addressed by the non-contact THz-speed writing and the contact lower-speed writing.

For the illustration, a CuMnAs/Si bit cell is chosen and the readout signal is plotted when applying 200 ms pulses of j = 1×10⁷ Acm⁻² by the contact method with alternating orthogonal current-path directions and a delay between pulses of 5 s. After 15 switches, the non- contact writing is added in the form of a 90-s long train of picosecond pulses with a kilohertz repetition rate and a current density j ≈ 1.6×10⁹ Acm⁻². The non-contact picosecond pulses induce an additional switching of the multi-level cell with the superimposed smaller switching signals controlled by the contact pulses.

### Discussion

The data presented in Figures 3 to 5 illustrate electrical spin torque switching can be used in the THz writing-speed range. At the GHz writing speed, the antiferromagnetic CuMnAs bit cells are written by current densities j ∼ 10⁸ Acm⁻². For the THz writing speeds, the applied current density in the antiferromagnetic devices increases only to a value of the order of j ∼ 10⁹ Acm⁻² and the writing energy remains comparable to that at the GHz writing speed. This can allow antiferromagnets to be used for electrically controlled memory devices in the THz band.

The result is in striking contrast to ferromagnets where the projected current and energy of the writing would increase by three orders of magnitude from the GHz to the THz writing speed. For 1/*τₚ* up to a GHz, the current density required for switching in spin-orbit torque memories fabricated in the common ferromagnetic transition-metal structures is ∼ 10⁸ Acm⁻² and only weakly deviates from the steady-current limit, owing to heat-assisted magnetization reversal. This current density corresponds to an effective field *H_{eff}*∼10-100 mT required for the switching of ferromagnetic moments over the magnetic energy barrier. However, when 1/*τₚ* is above the GHz threshold, the steady-current limit *H_{eff}* is no longer sufficient for switching because *τₚ* becomes comparable to or smaller than the limiting magnetization reorientation time-scale. This is given by 1/*f* where *f* = γ/2π *H_{eff} is* the ferromagnetic resonance frequency. To keepf in scale with 1/*τₚ*, the effective writing field, and therefore j, have to increase linearly with 1/*τₚ* above the GHz threshold.

In particular, *f* reaches 1 THz at about 30 T and the switching current density linearly extrapolated to the THz writing speed would be ∼10¹¹ Acm⁻² in the ferromagnetic spin orbit torque devices. This also means that while the writing energy ∼ j² *τₚ* initially drops down with increasing 1/*τₚ*, in ferromagnets it starts to increase linearly with 1/*τₚ* above the GHz threshold. A THz writing speed would then require three orders of magnitude higher energy than the GHz writing speed used in present MRAM devices. With these basic physical limitations, the current-induced spin-orbit torque switching has not been pushed in ferromagnetic MRAMs to 1/*τₚ* far exceeding 5 GHz.

On the other hand, the antiferromagnetic resonance frequency is exchange-enhanced and scales as *∼*sqrt(*H_{E}H_{A}*)*,* which puts it in the THz range. Here *H_{E}* is the inter-spin-sublattice exchange field and *H_{A}* is the anisotropy field (in the absence of externally applied fields). This enhancement of the antiferromagnetic resonance frequency and, correspondingly, of the threshold writing speed is due to canting of the antiferromagnetic spin sublattices when brought out of equilibrium. A uniform magnetic field required for switching is also exchange-enhanced in antiferromagnets and scales as ∼sqrt(*H_{E}H_{A}*), which typically takes it into the tens of Tesla range, inaccessible in microelectronic devices. However, the current-induced staggered field that is commensurate with the staggered Néel order in the antiferromagnet, for which the exchange-enhancement factor of the switching field amplitude is absent, is exploited. This allows antiferromagnets to reach THz writing speeds at accessible fields and energies.

It is noted that in the experiments hereinbefore described, electrical readout is performed at macroscopic time-delay scales compared to the picosecond-scale of the writing pulses, taking advantage of the memory effect in the antiferromagnetic CuMnAs bit cells.

### Fabrication

### -CuMnAs growth-

A CuMnAs film were grown on GaAs (001) or Si (001) by molecular beam epitaxy at a substrate temperature of 220 °C. X-ray diffraction measurements show that the film has a tetragonal Cu2Sb structure (space group P_{4/}nmm). The film and substrate follow the epitaxial relationship CuMnAS(001)[100]||GaAs(001)[110] or Si(001)[110]. The CuMnAs film thickness is 50 nm. Magnetic measurements confirmed that the CuMnAs film is a compensated antiferromagnet. The Néel temperature is 480 K and the resistivity *ρ* = 1.25 × 10⁻⁴ cm⁻¹.

### - Lithography-

Fabrication of the CuMnAs cross-shape cells 1₁ is done using electron beam lithography and reactive ion etching. Metal masks are used, prepared by lift-off method directly on the surface of CuMnAs films to define the pattern and protect CuMnAs layer during the reactive ion etching.

### Measurement

For the THz measurements, intense electro-magnetic radiation fields (at ∼1THz) are generated by optical rectification of laser pulses (center wavelength 800 nm, pulse duration 350 fs, pulse energy 4 mJ, repetition rate 1 kHz) from an amplified laser system in a 1.3 mol% MgO-doped stoichiometric LiNbO₃ crystal with the tilted pulse-front technique.

To determine the electric field component of the radiation, a (001)-oriented quartz crystal (having a thickness of 50 µm) is placed at the sample position where it induces a transient birefringence through the linear electro-optic effect. The birefringence and, therefore, the field is sampled step by step by a variably delayed optical laser pulse (2 nJ, 800 nm, 8 fs, 80 MHz) co-propagating through the electro-optic material. The electric field strength at the focus was calibrated by measuring the pulse energy by a power meter (Gentec THz-B) and the THz beam waist by transmission through an aperture. For the THz writing experiments, the sample is placed in the focus of the normally incident radiation beam. The two perpendicular polarization settings of the beam are realized by a wire-grid polarizer.

Fast switching using an antiferromagnetic photodiode device or an Auston-type switch Ultrafast electrical pulses can be generated optically using photo-electric switches.

Referring again to Figure 1b, the second type of antiferromagnetic device i2 is fabricated by patterning a GaAs/CuMnAs heterostructure to form a pillar 11. A reverse bias is applied and the build-in electric field at the p-i-n junction split laser-generated excitons (not shown) into electrons and holes (not shown). The electrons accelerate towards the CuMnAs metallic layer 14.

Referring again to Figure 1c, the third type of antiferromagnetic device 1₃ is based on an Auston switch fabricated using a layer of CuMnAs on low temperature GaAs substrate (which contains many recombination defects) and are embedded in co-planar waveguide 33₁, 33₂. Pulses are generated in an active area which is illuminated by 100 fs laser pulses.

Auston-switches have a smaller device capacitance compared to photodiodes so that the generated pulses have short pulse-fall times, in some cases as low as 1 ps. The fall time of the photodiodes are typically longer due to a larger device capacitance. For example, the decay time of the ∼100 µm diameter photodiode is about 20 ps. On the other hand, photodiodes can generate pulses of very short rise time, e.g. less than 1 ps, due to strong electric fields along the intrinsic recombination area of the reversed biased n-i-p junction. To trigger fast antiferromagnetic switching experiments by field-like spin-orbit torque (SOT), a short rise-time is more relevant for the fast switching than a short fall time. The device switched during the fast rise time and the switched state is not anymore affected during the rest of the pulse. Another benefit of photodiodes is the possibility to inject spin-polarised current pulses when photocarriers are generated by circularly-polarised light exploiting the optical selection rules in GaAs. In this case, antiferromagnetic excitation by the anti-damping-like spin-transfer torque (STT) excitation can support the Néel field-like SOT or trigger the switching by its own. The CuMnAs film, which is thin enough to be transparent to the incident light, is grown on top of the diode.

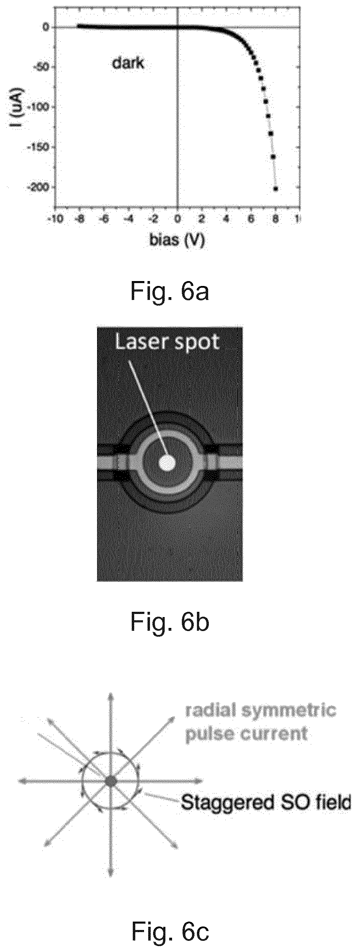

Referring to Figure 6a, large reverse fields can be applied in such structures.

Referring to Figures 6b and 6c, when an annular top electrode 19' is used and the laser 21 is focused in at the centre of the top of the pillar, current flows in radially-symmetric orientations towards the electrode 19' causing a staggered spin-orbit field of radial symmetry.

Current pulse rise- and fall-times as well as current amplitude can be estimated from a pulse-pulse time-correlation measurement.

### Read-out methods for biaxial and uniaxial switching

### Slow magneto-transport measurements

Current induced torques acting on the spin sub-lattices of antiferromagnets, such as CuMnAs or Mn₂Au, by staggered Néel ordered spin-orbit fields have shown efficient switching between orthogonal Neel vector states at room temperature. However, reversible switching employs a four-terminal device architecture where the writing current can be rotated by 90°. However, non-volatile antiferromagnetic memories in two-terminal devices can be realized using uniaxial switching between two energetically equivalent states of opposite Néel vectors or using biaxial switching.

Uniaxial switching in CuMnAs/Pt devices can be triggered by simply changing the writing pulse polarity. Magnetic switching in antiferromagnets, such as CuMnAs or Mn2Au, by electrical pulses has been observed using a direct AMR measurement.

Stable and deterministic switching between non-volatile states of opposite Néel vectors can be detected by employing a homodyne detection whereby an alternating probe current periodically tilts the antiferromagnetically coupled moments and resulting in a second harmonic signal proportional to the probing current amplitude as a result of the periodically changing anisotropic magnetoresistance.

Comparing uniaxial switching with switching between orthogonal Néel vector states in the same device at room temperature, the retention time of orthogonal switching can be short in case that the two orthogonal states are not necessarily equal in energy. On the other hand, uniaxial switching is usually more stable so that 180° switched states can be identified days after the writing pulse was applied. On the other hand, 90° switched states can retain only for a few minutes.

The second harmonics read-out (detection) method can provide additional information, such as the orientation of the antiferromagnetic Neel vector L after switching and the magnitude of the SOT. The method can also be used to study thermal activation processes and the effect of magnetic anisotropy modifications by mechanical strain.

CuMnAs, Mn2Au or another antiferromagnetic material having either biaxial, easy-plane, or uniaxial magnetocrystalline anisotropy can be used. A thin layer (e.g. ≤ 10 nm) of CuMnAs layer typically exhibits uniaxial anisotropy, whereas a thicker film (e.g. ∼50 nm) exhibits bi-axial or easy- plane anisotropy.

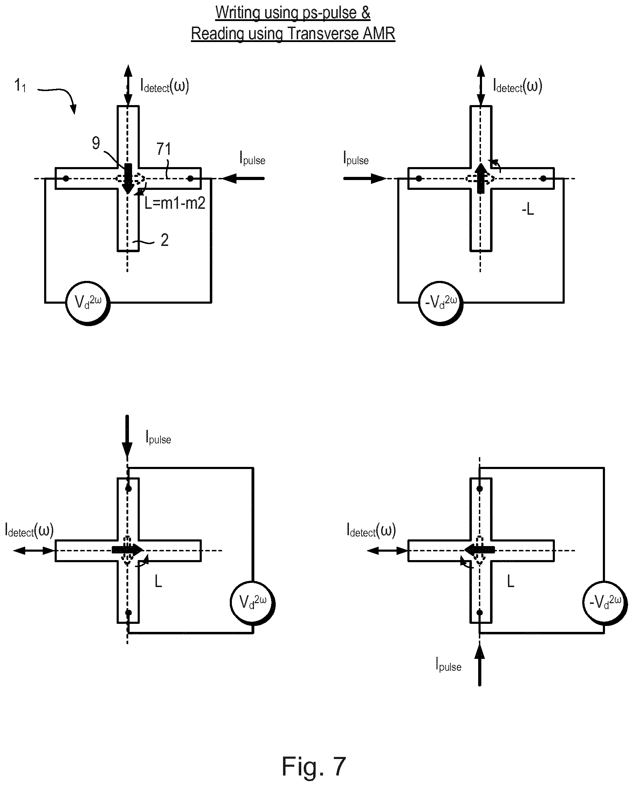

Referring again to Figure 7, transverse AMR (t-AMR) measured at the second harmonics (detection of transverse AMR signal at 2f (double frequency) of the if alternating probe current) can be used to identify the orientation of the antiferromagnetic Néel vector L after switching in a cross-shaped device 1. Combined with the current-pulse induced switching, current-induced effects can be detected before and after switching. In particular, second harmonic t-AMR signal can be used to identify the orientation of the Néel vector L after switching. Moreover, by comparing the first and second harmonics of the t-AMR signal, the magnitude of of the SOT field as a function of the driving current magnitude can be identified.

Referring also to Figure 7, applying a current pulse of sufficiently high current density rotates the Néel vector 9 perpendicular to the current direction 71. The orientation of the Néel vector L depends on the current polarity. Although both orientations are indistinguishable by first harmonics AMR resistance measurement, a weak alternating detection current I_{detect}(ω)= I_{d}·sin(ωt) periodically tilts the Néel vector L to either side of the antiferromagnetic bar 2 which will generates a transverse second harmonics voltage signal ∼AR_{t_AMR}^{∗} I_{d}·sin(2ωt), which is proportional to the Néel vector tilt-angle and changes sign under Néel vector reversal. ΔR_{t_AMR} is the amplitude of the transverse resistance variation due to the transverse AMR effect.

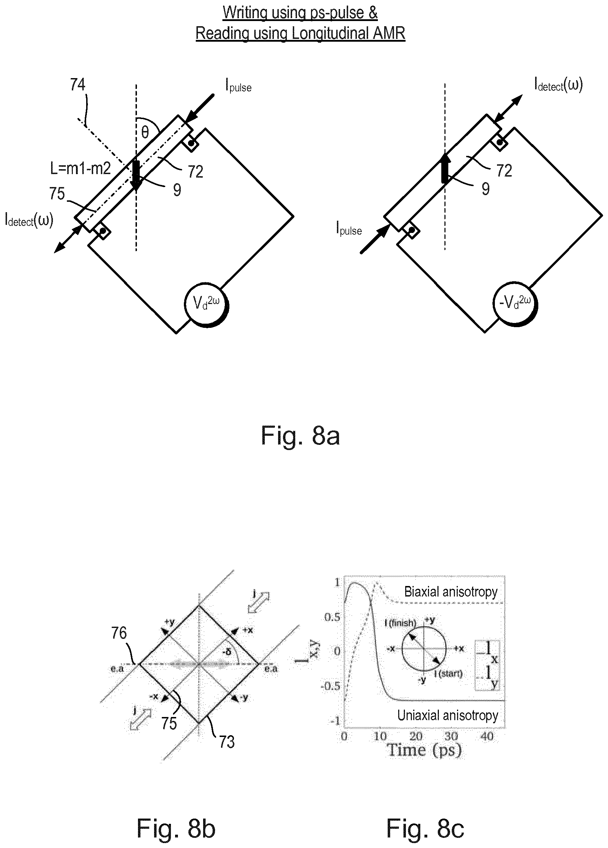

Referring to Figures 8a and 8b, read-out based on measuring second harmonics by performing longitudinal AMR measurements also allows to detect magnetic moment reversal in uniaxial materials (e.g. CuMnAs) patterned into a simple two-terminal bar structure 72 to be measured if the easy anisotropy axis and the current direction are not collinear.

Referring in particular to Figure 8b, the Néel vector 9 can be identified by a harmonics measurement of the longitudinal AMR if the easy axis 76 is rotated away from the direction 75 of the bar 72, by 45° in the optimal case.

Referring also to Figure 8c, current pulse polarity-dependent uniaxial switching of the Neel vector can be induced by a 10 ps long pulse. Switching is stable and without overshooting even for longer pulse durations. The switching of uniaxial CuMnAs in the two-terminal geometry is robust and independent of the switching pulse length.

### Fast time-resolved optical MLD measurements

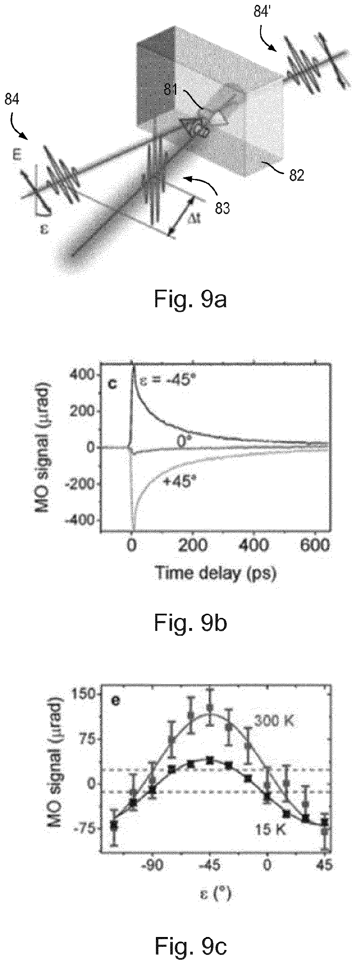

Referring to Figures 9a to 9c, detection of an antiferromagnetic state 81 in an antiferromagnetic region 82, for example of one of the devices 11, 12, 13 hereinbefore described, can be performed using a magnetic linear dichroism (MLD) measurement.

Referring in particular to Figure 9a, a first, pump laser pulse 83 is directed at the antiferromagnetic region 82. A second, probe laser pulse 84 which is linearly polarized and which is delayed, relative to the first pulse 83, by a time Δt is directed at the antiferromagnetic region 82. The antiferromagnetic region 82 absorbs light polarized along and perpendicular to magnetic moments 81 different which leads to a rotation of the linearly polarized light polarization plane of the transmitted probe pulse 84'.

Referring in particular to Figure 9b, pulse-induced local heating of the sample 81 leads to a demagnetization and, consequently, to a reduction of MLD-related probe polarization rotation, which is detected as a function of time delay between pump and probe pulses 83, 84 for various probe pulses polarization plane orientations.

Referring in particular to Figure 9c, time resolved pump-induced change of MO signal measured by probe pulses with different polarizations ε in transmission.

Further reference is made to V. Saidl et al.: "Optical determination of the Neel vector in a CuMnAs thin-film antiferromagnet", arXiv:1608.01941 (2016).

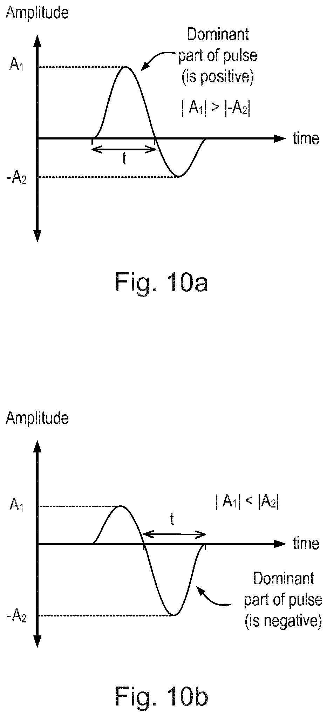

Referring to Figures 10a and 10b, pulses having dominant positive and dominant negative field amplitudes for switching a Neel vector L back and forth between two states in a uniaxial system are shown.

### Second harmonic measurement

A second-harmonic measurement involving a homodyne detection can be used for reading the state of a device. An alternating probe current periodically tilts the antiferromagnetically-coupled moments in the antiferromagnetic region due to the staggered spin-orbit field and a second harmonic signal proportional to probe current amplitude appears due to a periodically-changing anisotropic magnetoresistance.

As will be explained in more detail, this approach allows domains of opposite (or "reversed") Neel vector L to be detected which a traditional AMR measurement would not be able to detect. As mentioned earlier, thus technique can be used to identify magnetic moment reversal in antiferromagnetic regions with uniaxial anisotropy.

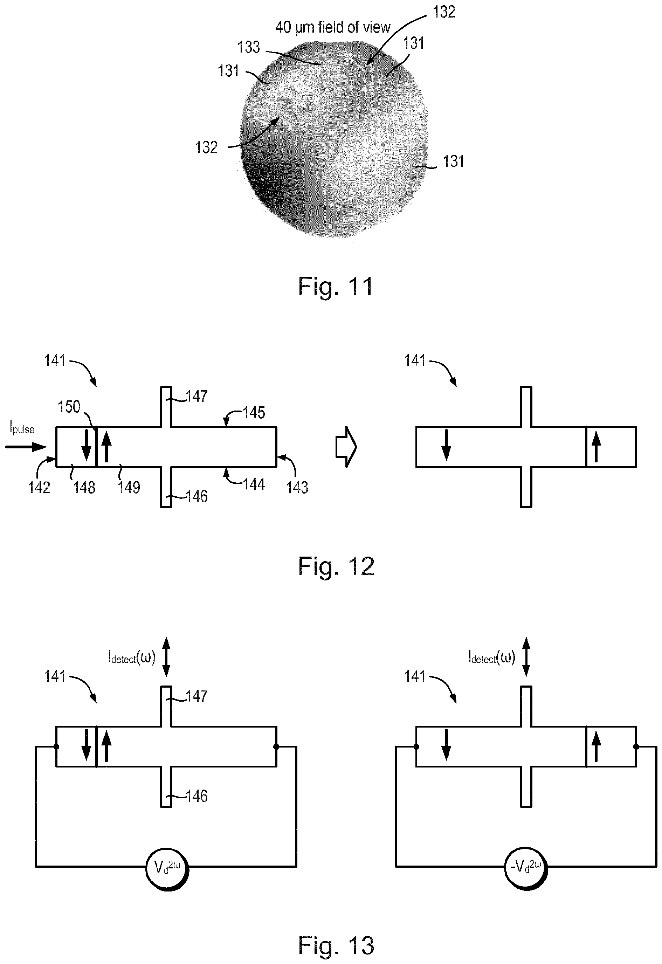

Referring to Figure 11, a photoemission electron microscopy (PEEM) x-ray magnetic linear dichroism (XMLD) micrograph of a CuMnAs antiferromagnetic sample having uniaxial domains is shown.

The micrograph shows antiferromagnetic domains 131 having opposite L vectors 132 separated by domain walls 133.

Referring to Figure 8a, Néel vector L reversal in a uniaxial system can be achieved using picosecond current pulses, even without moving domain walls. The anisotropy axis is inclines at an angle θ with respect to the current direction so as to be non-collinear and non-perpendicular to the current direction. Preferably, the angle θ is 45 °.

For second harmonic detection, advantage is taken of the fact that the AMR measurement and the SO-field generated by the measurement current is too small to cause switching (e.g. reversal) of the Néel vector 9. The Néel vector 9 traverses the applied current direction and changes sign when changing current direction.

The current acts on the Néel vector 9 in such a way such that the Néel vector 9. tilts towards the bar 72. For example, for a positive detection current, the current tilts the Neel vector 9. towards an axis 74 perpendicular to the bar 72.

Tilt of the Néel vector 9. varies the resistance of the bar 72 due to the AMR effect. For example, when the Néel vector 9. tilts towards the bar 72 (i.e. closer to the longitudinal axis 75 of the bar), the resistance increases, whereas when the Néel vector 9. tilts towards the towards perpendicular 74 of the bar 72, the resistance decreases. Thus, the resistance follows a relationship R(Iₘₑₐₛ)=R₀ +/- ΔR_{AMR}(|Iₘₑₐₛ|). For a small tilt angle, ΔR_{AMR} is proportional to the tilt angle Δθ and, therefore, proportional to the measurement current.

Since the staggered SO field vector depends on the current and not on the Néel vector, the Néel vector is tilted in the opposite direction after reversal, e.g., towards perpendicular 74 to the bar 72 for positive detection current and towards the parallel 75 of the bar 72 for negative detection current.

Referring still to Figure 8a, if an alternating detection current is applied having a frequency *f* = ω × 2π, then multiplying (or "mixing") the measured longitudinal resistance signal with ∼sin(2ωt+π/2) results in a time-averaged multiplied signal which is proportional to ΔR_{AMR}(|Iₘₑₐₛ|) and, therefore, changes sign when the Néel vector reverses.

Referring also to Figure 7, the same approach can be used for a transverse AMR measurement in case of a cross bar 71. In this case, resistance variation of the transverse resistance of the second harmonics can distinguish Néel vector 9. reversals with the Néel vectors 9 aligned collinear to the detection current.

Referring to Figure 12, another bar structure 141 is shown. The bar structure 141 is similar to the bar structure 71 (Figure 8a), for example it comprises a layer of antiferromagnetic material in the form of CuMnAs having a thickness of about 50 nm and a length of between 200 nm and 1 µm, and exhibits uniaxial anisotropy. The uniaxial anisotropy may be strain-induced and aligned perpendicular to the bar due to strain-relaxation of the narrow bar. The CuMnAs maybe strained due to the lattice mismatch between substrate (e.g., GaAs) and antiferromagnetic layer (CuMnAs). The bar 141 extends between first and second ends 142, 143 and has first and seconds lateral sides 144, 145. The bar 141 is provided with first and second 146, 147 lateral arms (or "leads") for measuring performing a transverse measurement. The antiferromagnetic bar includes first and second domains 148, 149 separated by a 180° domain wall 150.

Switching of the state can be realised by domain wall propagation by applying a suitable picosecond pulse Iₚᵤₗₛₑ along the bar 141. Domain wall propagation is reversible and switching of the state can be realised by applying a suitable picosecond pulse Iₚᵤₗₛₑ along the bar 141 of opposite current pulse polarity.

Referring to Figure 13, a detection signal I_{detect} is generated where the bar 141 and transverse contacts 146, 147 cross. The signal contains the ΔR_{AMR}(|Iₘₑₐₛ|) component, but not the AMR- independent offset R₀ making the detection easier.

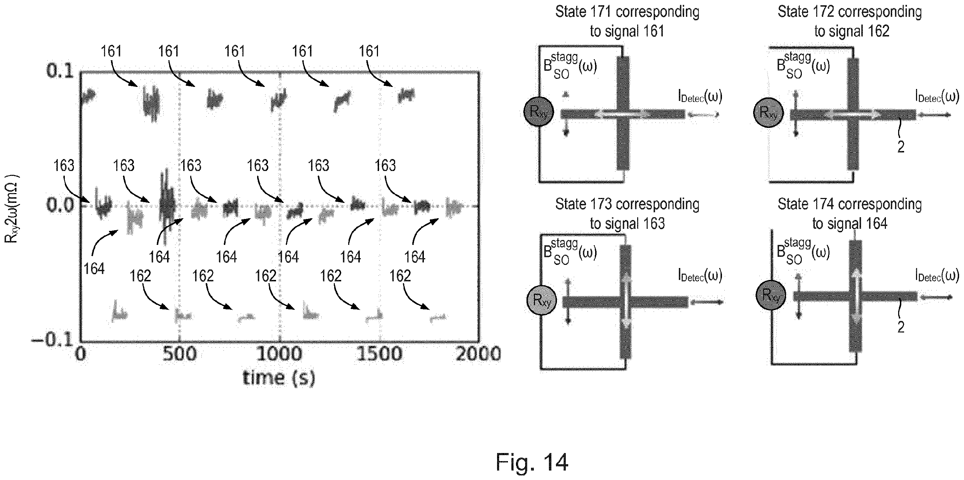

Referring to Figure 14, experimental results showing reading of states using second harmonic measurement for four different Néel vector orientations are shown. The device is similar to that shown earlier and comprises a layer of antiferromagnetic material in the form of CuMnAs having a thickness of about 10 nm and a thin layer of Pt on top of the CuMnAs of about 3nm.

The measurements can be used to identify reversal of the Néel vectors 9.

When the L-vector (i.e. Néel vector) is aligned collinear to the detection current, then signal 161, 162 shows reversed domains and so the two states can be identified. When the L-vector is aligned perpendicular to the current, then then the states 163, 164 cannot be distinguished.

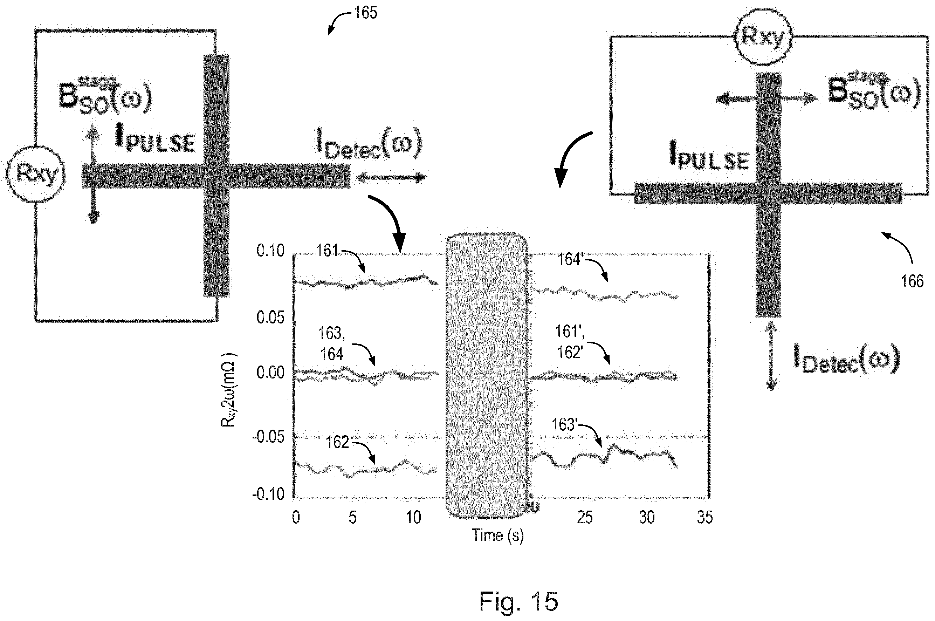

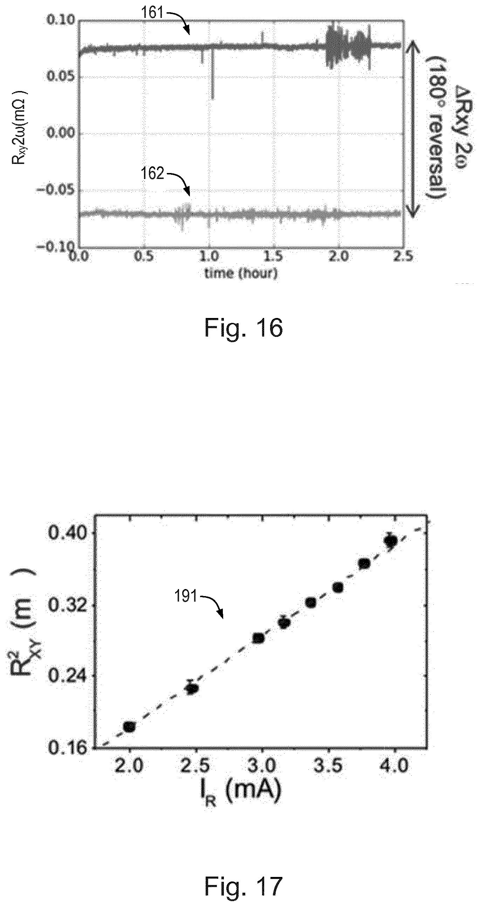

Referring also to Figure 15, the measurement arrangement 165 shown in Figure 16 ("the first measurement arrangement") and a by 90 deg. "rotated" measurement arrangement 166 16 ("the second measurement arrangement") is shown for the same device, i.e. the device whose results are shown in Figure 16. The second measurement arrangement 166 is rotated by 90° with respect to the first measurement arrangement 165 and now can now distinguish the reversed L vector along the vertical bar, i.e. on the device shown on the right-hand side. The modified signals 161', 162', 163', 164' measuring the same states 171, 172, 173, 174 shown in Figure 16. It can be seen that, whereas the signals 163, 164 in Figure 16 could not be used to distinguish between states 173, 174, the signals 163', 164' can now be resolved.

Referring to Figure 16, the 180° reversed states 171, 172 (Figure 16) have a long retention times since the two states 161, 162 are energetically identical (at zero applied SO field). As shown in Figure 17, the states are easily distinguishable states up to three hours. The states could still be distinguished two days later, without any sign of decrease in retention.

Referring to Figure 17, a plot 191 shows that measured 2ω signal is as expected proportional to the applied detection current amplitude since the transverse AMR signal is proportional to the tilt angle and since, for small tilt angles, the tilt angle is proportional to the current amplitude.

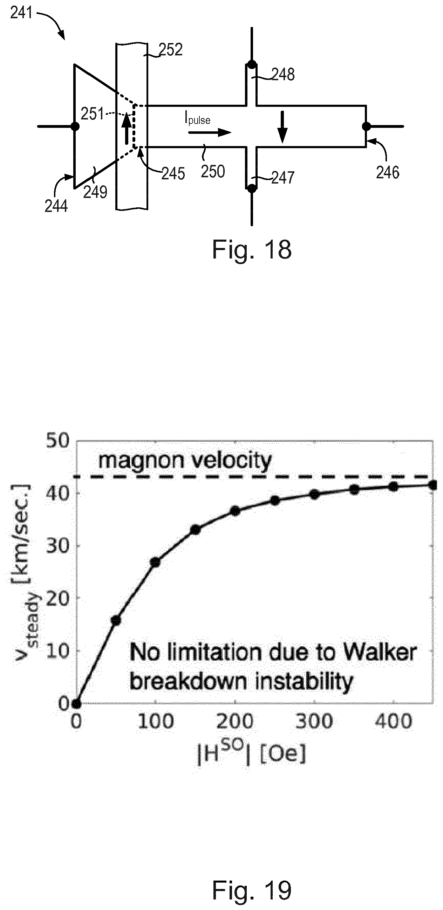

Referring to Figure 18, a modified bar structure 241 is shown.

The bar structure 241 is similar to that shown in Figure 14 except that the structure includes a trapezoidal section 242 and straight section 243 formed in a layer of CuMnAs or other suitable antiferromagnetic material having a thickness, for example, of 50 nm. The trapezoidal section 242 tapers from a wide end 244 and a narrow point 245 (or "junction" or "throat") and the bar extends from the junction 245 between the two sections 242, 243 to an end 246. The bar structure 241 includes lateral contacts 247, 248. The antiferromagnetic bar includes first and second domains 249, 250 separated by a transverse domain wall 251.

The bar structure 241 is provided with a conductive strip 252 (or "heater") running over the narrow end 245 of the trapezoidal section 242. The strip 252 may be separated from the bar 241 by a layer of dielectric material, such as aluminium oxide or silicon dioxide (not shown).

States in the bar 241 can be written using picosecond current pulse(s) as hereinbefore described. However, the process is assisted by the tapering of the bar, which increases current density at the junction 242 and can be assisted further by locally heating the bar 241 at the junction 242. The current creates a staggered SO field along moment orientation in a nucleated area under the heater 252.

The state can be read using the second harmonic process hereinbefore described.

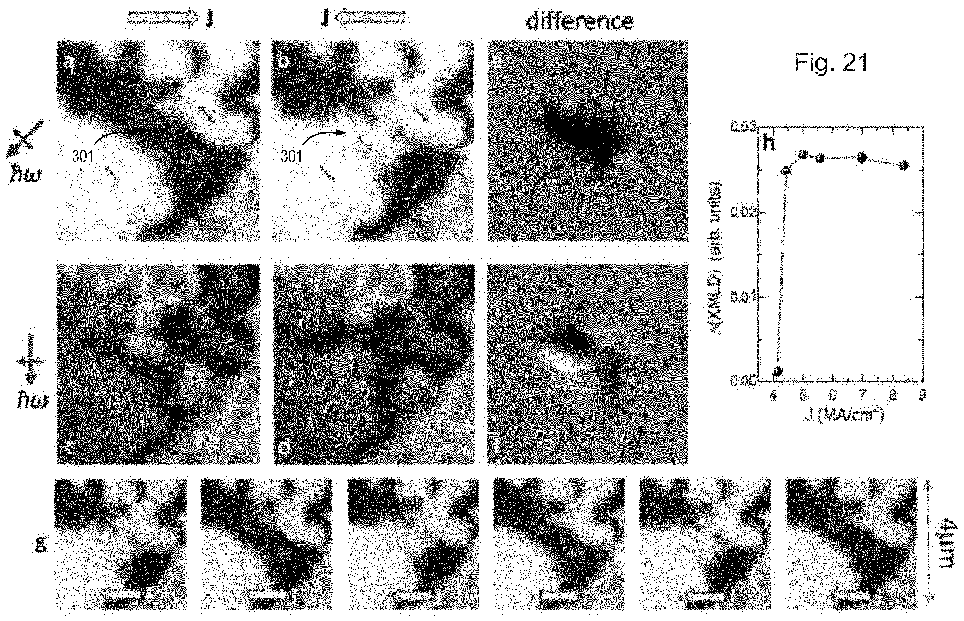

Referring to Figure 21, a plot of domain wall velocity against spin-orbit field is shown.

### Reversible manipulation of antiferromagnetic domain walls using electrical currents

Reversible current-induced domain wall motion is achievable in an epitaxial CuMnAs film. Electrical read-out signal is independent of the polarity of the writing current and reconfiguration of antiferromagnetic moments can be achieved by applying current pulses in orthogonal directions. On a local level, however, writing current polarity can play an important role as it determines the domain wall propagation direction.

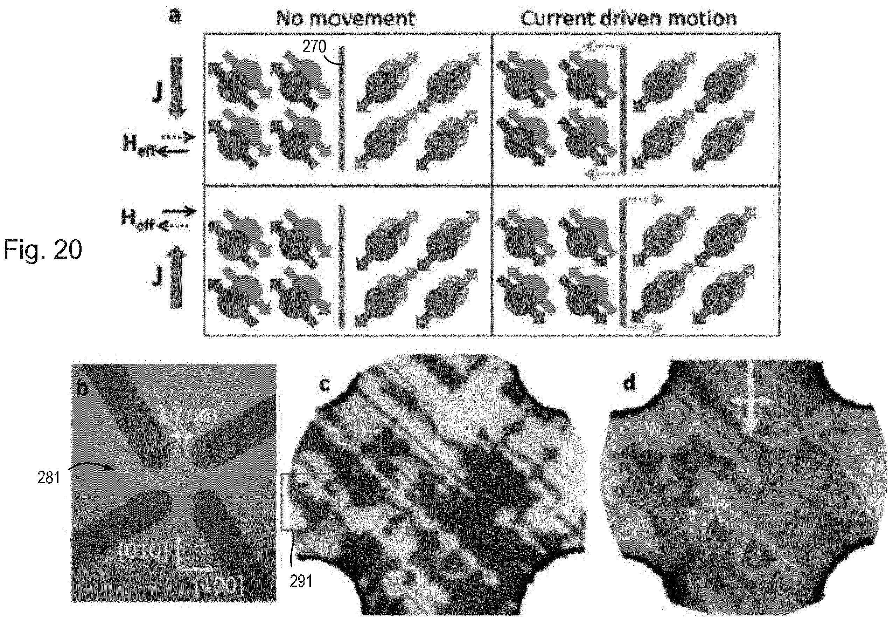

Referring to Figure 20a, writing currents can be applied at 45° to the biaxial easy magnetic axes of the CuMnAs crystal. The out-of-plane c-axis is energetically unfavourable in tetragonal CuMnAs, so the spins align in the plane of the film throughout the domain wall 270. The current-induced effective magnetic fields are orthogonal to the current direction and are in opposite directions for each sublattice.

As shown in Figure 20a, antiferromagnetic domain wall motion due to Néel-order spin-orbit torque (NSOT) can be expected in a direction which depends on the polarity of the current pulse (J), when there is a difference in energy density of the domains on either side of the domain wall. Moreover, due to the absence of the Walker breakdown in case of antiferromagnetic domain walls, much faster domain wall motion is expected compared to ferromagnets, where the velocity is limited by Walker breakdown.

Figure 20b is an optical micrograph for a 10µm cross structure 281 fabricated from a 45nm thick CuMnAs film.

Figures 20c and 20d are antiferromagnetic domain images of the 10µm cross structure shown in Figure 20b obtained using x-ray photoemission electron microscopy (XPEEM), with contrast due to x-ray magnetic linear dichroism (XMLD). The XMLD signal varies as Acos²*φ*, where *φ* is the angle between the magnetic moment and the x-ray polarization vector. The pre-factor A depends on the orientation of the polarization with respect to the crystal axes, and is opposite in sign for polarization along the CuMnAs [1-10] (shown in Figure 20c) and [100] (shown in Figure 20d) crystal axes.

Referring in particular to Figure 20c, the large degree of black-white contrast indicates a biaxial magnetic anisotropy, with the antiferromagnetic moments aligned predominantly with the [110]/[1-10] axes.

Referring in particular to Figure 20d, the black-white contrast is predominantly at the boundaries of the domains seen in Figure 20c.

Figure 21 shows the polarity-dependent switching within a 4 µm × 4 µm region marked 291 (shown in Figure 20b). Electrical current pulses are applied along the [100] oriented arm of the device, with alternate polarity.

Figures 21a and 21b show switching of a centre 301 of the image from dark to light, corresponding to a rotation of the staggered magnetization from the [110] to the [1-10] orientation.

Figures 21c and 21d show the same region viewed with the x-ray linear polarization along the [100] axis, where it can be seen that an approximately 100nm wide domain wall has moved from one side of the switched region to the other.

Referring to Figures 21e and 21f, the differences between the images obtained after opposite polarity current pulses show clearly that the current-induced switching is localized in a ≈2µm x 1µm region 302 in the centre of the image.

Figure 21g shows the reproducibility of the switching over several reversals of the polarity of the current pulse.

Referring also to Figure 21h, the net difference between the domain images, averaged across the whole 4µm x 4µm square, shows a sharp onset at a current density of ≈4.4 MA/cm2, with no further changes up to the highest currents applied.

### Fabrication

The 45nm CuMnAs film was grown on a GaP buffer layer on a GaP (001) substrate at 26000C, and capped with a 2nm Al film to prevent surface oxidation. In-situ reflection high energy electron diffraction measurements confirmed the tetragonal structure of the layer, with the epitaxial relationship CuMnAs(001)[100]||GaP(001)[110]6. The crystallographic axes described in the main text correspond to those of the CuMnAs film. The device structures were fabricated by optical lithography and wet etching, with electrical contacts made by wire-bonding to Cr/Au pads.

### XPEEM imaging

The XPEEM measurements were performed at room temperature on beamline I06 at Diamond Light Source, using linearly polarized x-rays. Magnetic contrast with approximately 30nm spatial resolution was obtained from the difference in the absorption signal measured by XPEEM at the peak and the minimum of the Mn L₃ XMLD spectrum. The electrical current pulses of duration 2.5ms and varying amplitude were applied in-situ.

### Electrical measurements.

All the electrical measurements were performed at room temperature using the geometry illustrated in Fig. 4a. Current pulses of duration 50ms and varying amplitude were applied. Probing was performed using dc currents of amplitude 0.5 mA (0.05 MAcm²). The resistivity of the devices was around 2×10⁻⁴Ωcm at room temperature.

Comparison of devices employing different combinations of switching and readout Antiferromagnetic devices hereinbefore described can generally take the form of a layer of CuMnAs or other suitable antiferromagnetic material having a cross-shape configuration which can be used for both 90° switching and 180° switching and read out. The devices capable of fast switching, such as a THz-radiated cross-shaped device, a p-i-n diode-based device, or an Auston switch-based device may comprise or be part of a cross-shape device. For example, the Auston switch can be implemented in a bar along which the switching current is applied and a cross bar can be used for sending a read current to identify the state, similar to the arrangement shown in Figure 15.

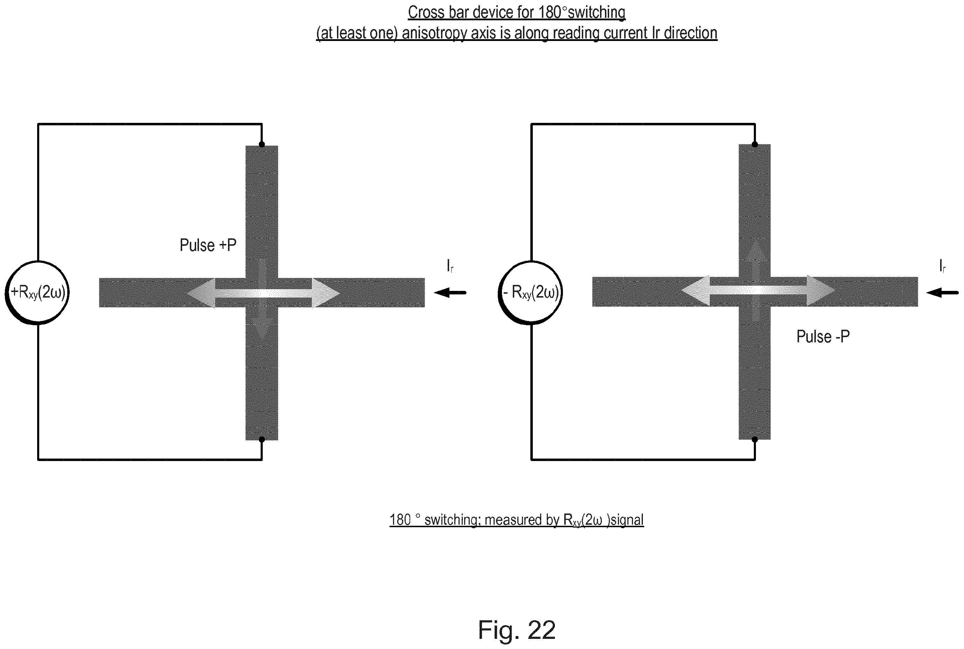

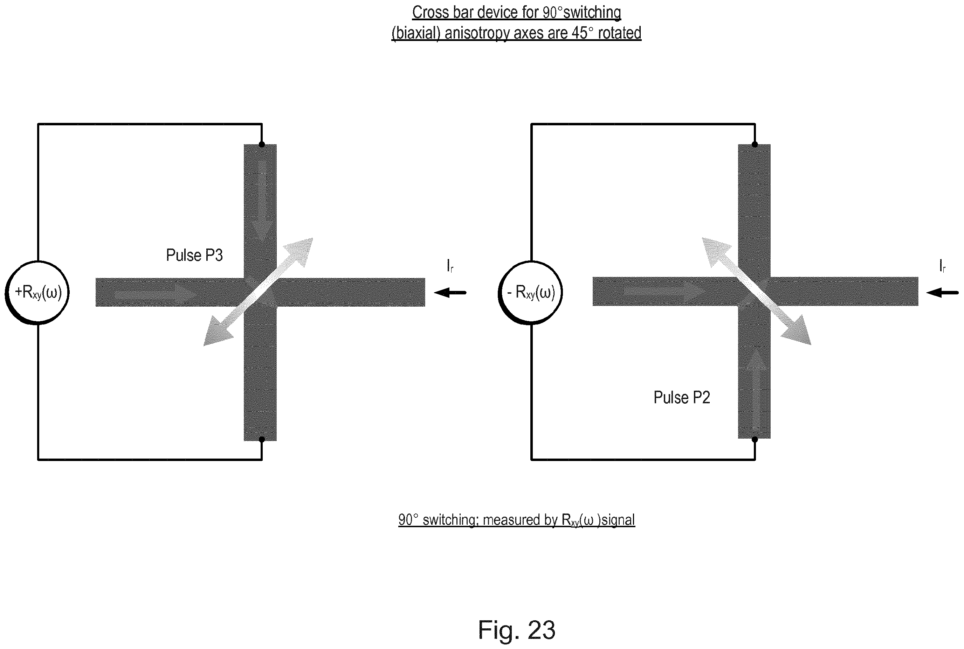

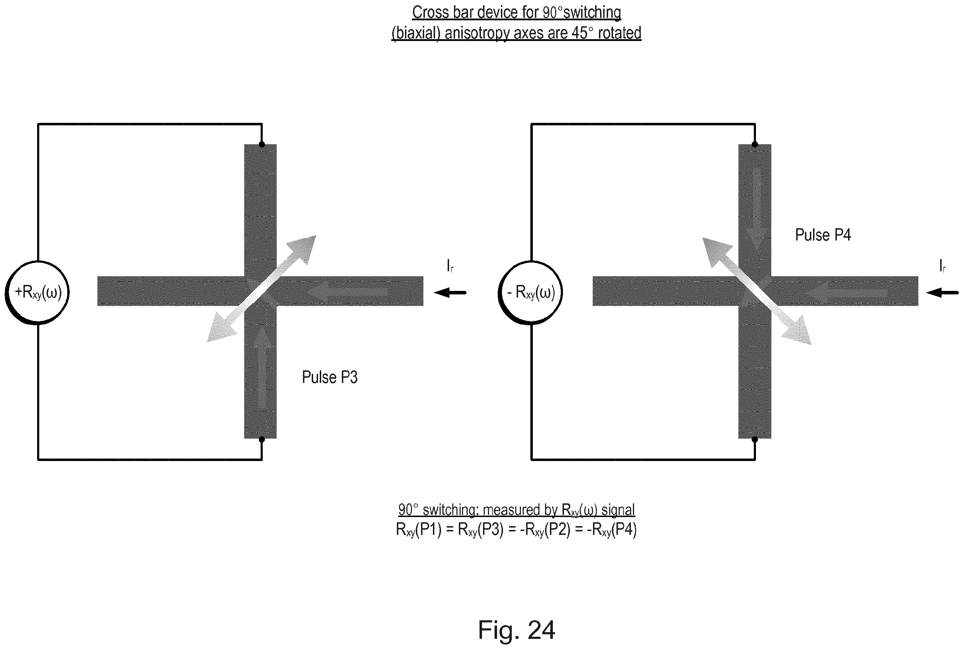

Referring to Figures 22 to 24, a simple cross-bar device can be used 180° switching or 90° switching, and read out. Switching along main and diagonal directions in the sane device is possible if there is no or only very weak anisotropy along arbitrary axes.

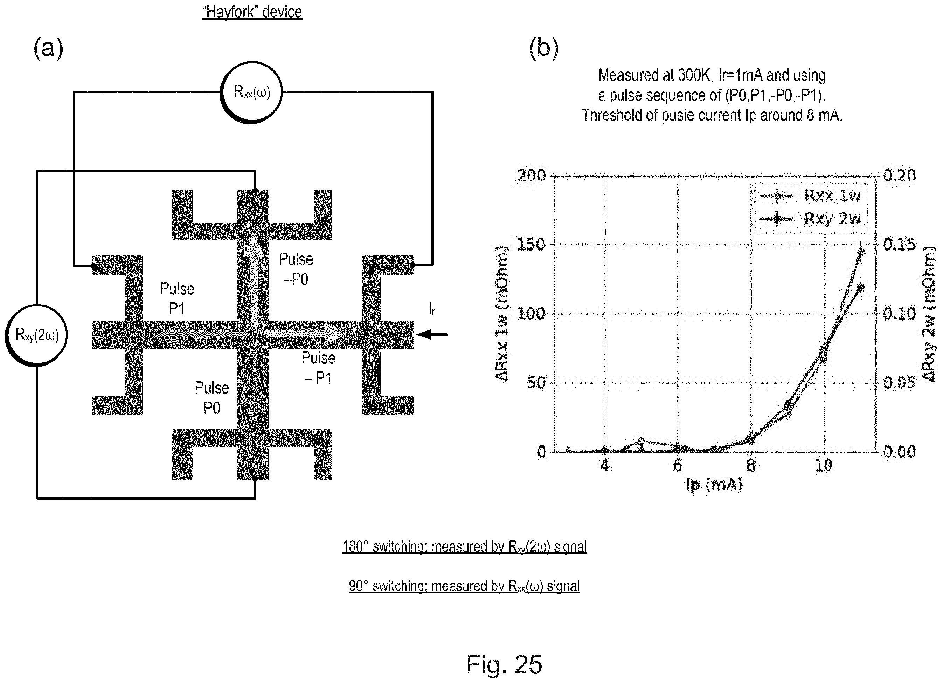

Referring to Figure 25a, a device can be used to perform 180° and 90° switching in the same device with pulses flowing only along one of the two cross bars. To identify 90° switching, longitudinal AMR measurements at first harmonics can be made. A hayfork arrangement can be used on each arm of the cross to allow both transverse and longitudinal measurements.

Referring to Figure 25b, 90° switching and 180° switching appear at the same current density.

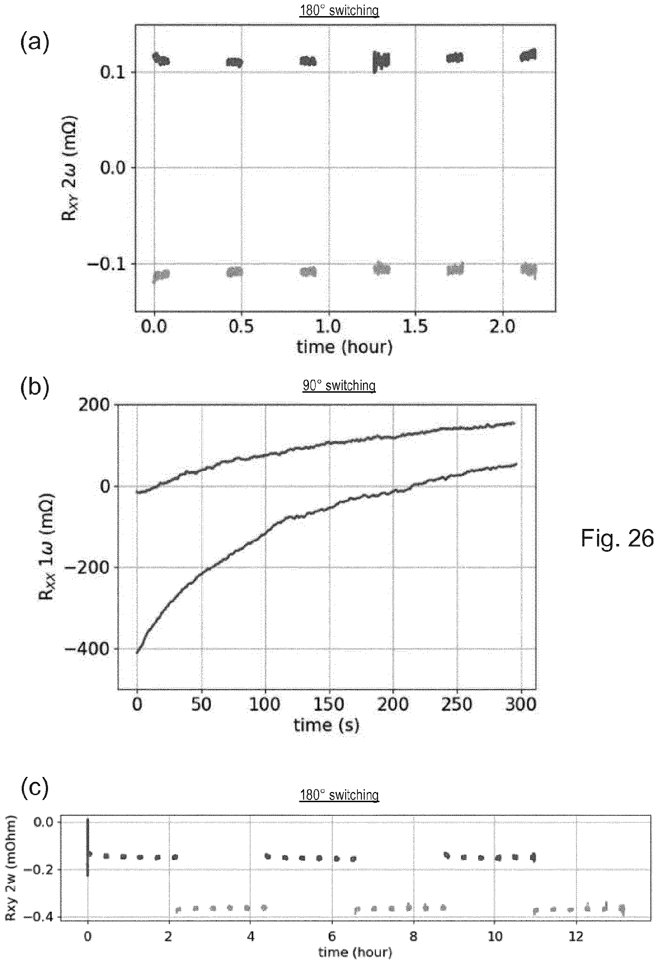

Referring to Figure 26a, an upper plot shows 180° switching after pulses with only opposite polarity have been applied.

A single pulse of opposite polarity is applied after more than 2 hours. Measurements of R_{xy}(2ω) are performed between pulses. Without wishing to be bound by theory, it is thought that this switching occurs by motion of 180° domain wall, as shown in Figure 15.

Referring to Figure 26b, a plot shows Rₓₓ(ω) measurements after two 90°-rotated pulses are applied. The difference between Rₓₓ(Po) - Rₓₓ(P1) is a measure of the difference in the averaged Néel vector orientation in the cross bar after pulse Po has been applied and after P1 has been applied. As can be seen from Figure 26c, the difference decays within minutes.

Figure 26a shows a long retention time in case of 180° switching.

Referring to Figure 26c, a single pulse of opposite polarity is applied only after more than 2 hours. Measurements of R_{xy}(2ω) are performed during the two-hour waiting time which show that the signal does not decrease.

### TAMR readout

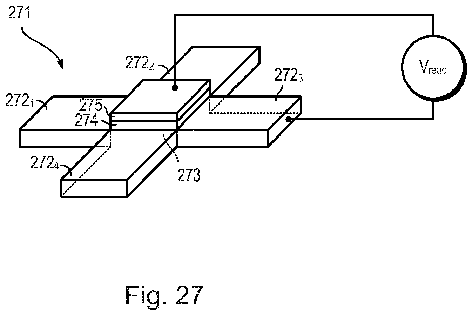

Referring to Figure 27, a modified cross-shaped device 271 is shown.

The device 271 comprises a cross-shaped layer 272 of CuMnAs or other suitable antiferromagnetic material. The device 271 comprises first, second, third and fourth arms 272₁, 272₂, 272₃, 272₄ joined at a central region 273. A dielectric layer 274 is disposed on the central region 273 of the cross-shaped antiferromagnetic layer 272 and a conductive layer 275 providing a counter electrode is disposed on the dielectric layer 274. The dielectric layer 273 may be formed from silicon dioxide, silicon nitride or other suitable dielectric material and is sufficiently thin to form a tunnel barrier, e.g. having a thickness between 1 nm and 6 nm.

The state of the device may be read using tunnelling anisotropic magnetoresistance (TAMR). Further details are disclosed in B. G. Park et al.: "A spin-valve-like magnetoresistance of an antiferromagnet-based tunnel junction", Nature Materials, volume 10, page. 347 (2011).

### Joule heating assisted writing

The devices herein described may be provided with a conductive line (e.g. a wire or track), for example formed from aluminium, having a sufficiently small transverse cross-sectional area such that the line heats up when a current passes through the conductive line. The conducive line may be formed from a heavy metal and may additionally provide spin generation and injection.

The conductive line may take the form of a layer disposed over or under an antiferromagnetic layer. The conductive line may have the same pattern (in plan view) as the antiferromagnetic layer, i.e. be coterminous.

The conductive line and the antiferromagnetic layer may be in direct contact. For example, the conductive layer may be formed on the antiferromagnetic layer. Alternatively, the conductive line and the antiferromagnetic layer may be separated by a dielectric layer.

If the conductive line and the antiferromagnetic layer, then conductive line preferably comprises a material having a smaller resistivity than the resistivity of the antiferromagnetic region and so more joule heating occurs in the conductive line than the antiferromagnetic region.

### Optical readout

Optical readout can be used to read-out the state of the antiferromagnetic memory device on a very fast time scale. For example, time-resolved optical MLD measurement can be used. Alternatively, optical read-out can be implemented using a stroboscopic pump-probe measurement using a THz-pulse ("pump") and an optical laser pulse ("probe") to detect rotation and ellipticity variations due to linear dichroism.

### Antiferromagnetic materials

As explained earlier, the antiferromagnetic region (or "element") comprises CuMnAs. However, other antiferromagnetic materials that generate a staggered effective field acting efficiently on the antiferromagnetic order may be used.

Staggered spin-orbit fields can cause field-like torque switching for materials where magnetic moments sit on lattice positions where local inversion symmetry is broken and where the inversion asymmetry for moments at a first sub-lattice A is opposite to the inversion asymmetry for moments in a second sub-lattice B.

The antiferromagnetic region, such as CuMnAs, may have a thickness between 5 nm and 100 nm. Preferably, the thickness is between 10 nm and 50 nm. Examples of antiferromagnetic regions herein described include layers of CuMnAs having a thickness of 10 nm or 45 to 50 nm. However, other thicknesses of CuMnAs, for example, 5 nm and 100 nm, preferably between 10 and 50 nm, can be used.

### Non-volatile memory

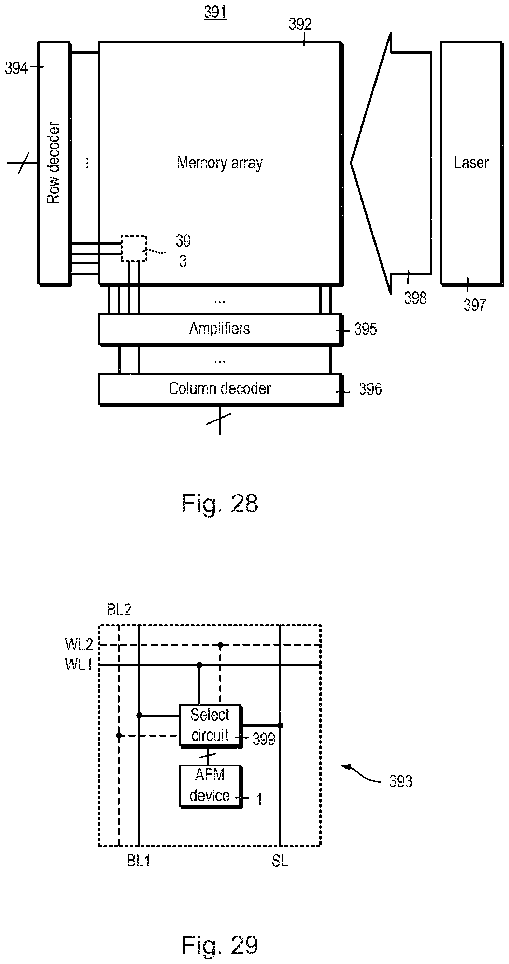

Referring to Figure 28, a non-volatile memory 391 is shown. The memory 391 includes an array 392 of cells 393, a row decoder 394, sense amplifiers 395 and a column decoder 396. The laser 397 may also be provided to provide a global, picosecond laser pulse 398.

Referring also to Figure 29, each cell 393 is based on an antiferromagnetic memory device hereinbefore described. The cell 393 includes a selection circuit 399 for selecting appropriate electrodes, e.g. pairs of electrode 19 (Figure 1b), to enable programming and reading of data. The circuit 399 includes one or more transistors. A word line WL1, an optional second word line WL2, a bit line BLi and an optional second bit line BL2 are connected to select circuit 399 which is connected to the electrodes the memory device 1. A sense line SL is connected to the selection circuit 399.

CMOS circuitry can enable writing using pulses below 100 ps, even as low as 10 ps. Nevertheless, the use of a global picosecond laser pulse 398 can be used to facilitate writing.

The antiferromagnetic memory can be operable as multi-level memory, i.e. more than simply storing '0' and '1', wherein the number of write pulses is used to increase a readout signal.

### Modifications

It will be appreciated that various modifications may be made to the embodiments hereinbefore described. Such modifications may involve equivalent and other features which are already known in the design, manufacture and use of antiferromagnetic memory devices and component parts thereof and which may be used instead of or in addition to features already described herein. Features of one embodiment may be replaced or supplemented by features of another embodiment.

The device can operate at room temperature, i.e. at about 22 °C. However, the device may operate a higher temperature. For example, the device may be heated, for example by Joule heating, to facilitate switching during pulse exposure. Heating a specific antiferromagnetic memory element (or "cell") in an array of antiferromagnetic memory elements (or "cells") can be used to address the element (or "cell") when exposing the array of elements simultaneously by pulse exposure.

The scope of protection of the present invention is defined by the appended claims 1-15.

## Claims

1. A method comprising:
generating at least one current pulse in an antiferromagnetic region (2) of an antiferromagnetic memory device (1₁), the antiferromagnetic region consisting of an antiferromagnetic material exhibiting inversion asymmetry of spin-sublattices;
wherein a portion of the or each current pulse has a duration less than 250 ps and a magnitude which is sufficiently high such that an electric field strength of at least 10⁵ V cm⁻¹ is generated in the antiferromagnetic region so as to induce a staggered spin-orbit field strong enough to switch magnetic moments in at least a portion of the antiferromagnetic region, wherein the portion of the or each current pulse causes the switching of the magnetic moments, and wherein generating the least one pulse comprises:
exposing the antiferromagnetic region to at least one gigahertz or terahertz pulse (5) of electromagnetic radiation which is elliptically or linearly polarized.

2. The method of claim 1, wherein a dominant polarization component is co-linear to the Neel vector of the antiferromagnetic region (2) before switching.

3. A method comprising:
generating at least one current pulse in an antiferromagnetic region (14; 31) of an antiferromagnetic memory device (12, 13) which is in electrical contact with, or forms part of, a photocarrier generator (12; 34), the antiferromagnetic region consisting of an antiferromagnetic material exhibiting inversion asymmetry of spin-sublattices;
wherein the current pulse has a duration less than 250 ps and a magnitude which is sufficiently high such that an electric field strength of at least 10⁵ V cm⁻¹ is generated in the antiferromagnetic region so as to induce a staggered spin-orbit field strong enough to switch magnetic moments in at least a portion of the antiferromagnetic region, wherein generating the pulse comprises:
exposing the photocarrier generator to at least one optical pulse (21; 36), the or each pulse having a duration less than 250 ps.

4. The method of claim 3, wherein the antiferromagnetic region (14; 31) is disposed on the photocarrier generator (12; 34).

5. The method of claim 3 or 4, wherein the optical pulse (21; 36) has a wavelength corresponding to a band gap of a semiconductor material in the photocurrent generator (12).

6. The method of claim 3, 4 or 5, wherein the photocarrier generator (12) comprises a p-i-n diode provided with a first electrode (18) and the antiferromagnetic region is provided with at least two second electrodes (19), wherein the method further comprises:
reverse-biasing the p-i-n diode between the first electrode and at least two of the second electrodes.

7. The method of claim 3 or 4, wherein the photocarrier generator (34) is a photoconductive switch, such as an Auston switch.

8. The method of any one of claims 3 to 7, wherein the device further comprising a metal layer disposed on the antiferromagnetic region (12; 31).

9. The method of any preceding claim, wherein the antiferromagnetic region (2; 12; 31) comprises an antiferromagnetic material exhibiting bulk inversion asymmetry.

10. The method of any one of claims 1 to 9, wherein the antiferromagnetic region (2; 12; 31) comprises an alloy which includes manganese.

11. A method comprising:
programming a state of the antiferromagnetic region (2; 12; 31) using the method of any preceding claim; and
reading the state of the antiferromagnetic region.

12. The method of claim 11, wherein reading the state of the antiferromagnetic region (2; 12; 31) comprises:
performing an anisotropy magnetoresistance measurement.

13. The method of claim 11 or 12, wherein reading the state of the antiferromagnetic region (2; 12; 31) comprises:
measuring the voltage response at double frequency to an alternating probe current.

14. The method of claim 11, wherein reading the state of the antiferromagnetic region (2; 12; 31) comprises:
performing an optical measurement.

15. Apparatus comprising:
an array of antiferromagnetic memory devices (1₁, 1₂, 1₃), each antiferromagnetic memory comprising a respective antiferromagnetic region (2; 12; 31), the antiferromagnetic region consisting of an antiferromagnetic material exhibiting inversion asymmetry of spin-sublattices;
a laser (6; 397) configured to provide at least one pulse to the array of antiferromagnetic memory devices;
a selection circuit (399) connected to each antiferromagnetic memory device and configured to program and read the antiferromagnetic memory device;
wherein the laser and the selection circuit are configured to perform the method of any one of claims 1 to 14.

## Patentansprüche

1. Verfahren, umfassend:
Erzeugen von zumindest einem Stromimpuls in einem antiferromagnetischen Bereich (2) einer antiferromagnetischen Speichervorrichtung (1₁), wobei der antiferromagnetische Bereich aus einem antiferromagnetischen Material besteht, das Inversionsasymmetrie von Spin-Untergittern aufweist;
wobei ein Teil des oder jedes Stromimpulses eine Dauer von weniger als 250 ps und eine Größe aufweist, die ausreichend hoch ist, sodass eine elektrische Feldstärke von zumindest 10⁵ V cm⁻¹ in dem antiferromagnetischen Bereich erzeugt wird, um ein gestaffeltes Spin-Bahnfeld zu induzieren, das stark genug ist, um magnetische Momente in zumindest einem Teil des antiferromagnetischen Bereichs zu schalten, wobei der Teil des oder jedes Stromimpulses das Schalten der magnetischen Momente bewirkt, und wobei das Erzeugen des zumindest einen Impulses Folgendes umfasst:
Aussetzen des antiferromagnetischen Bereichs zumindest einem Gigahertz- oder Terahertz-Impuls (5) von elektromagnetischer Strahlung, die elliptisch oder linear polarisiert ist.

2. Verfahren nach Anspruch 1, wobei eine dominante Polarisationskomponente vor dem Schalten kolinear zu dem Néel-Vektor des antiferromagnetischen Bereichs (2) ist.

3. Verfahren, umfassend:
Erzeugen von zumindest einem Stromimpuls in einem antiferromagnetischen Bereich (14; 31) einer antiferromagnetischen Speichervorrichtung (1₂, 1₃), die in elektrischem Kontakt mit einem Phototrägergenerator (12; 34) ist oder einen Teil davon bildet, wobei der antiferromagnetische Bereich aus einem antiferromagnetischen Material besteht, das Inversionsasymmetrie von Spin-Untergittern aufweist;
wobei der Stromimpuls eine Dauer von weniger als 250 ps und eine Stärke aufweist, die ausreichend hoch ist, sodass eine elektrische Feldstärke von zumindest 10⁵ V cm⁻¹ in dem antiferromagnetischen Bereich erzeugt wird, um ein gestaffeltes Spin-Bahnfeld zu induzieren, das stark genug ist, um magnetische Momente in zumindest einem Teil des antiferromagnetischen Bereichs zu schalten, wobei das Erzeugen des Impulses Folgendes umfasst:
Aussetzen des Phototrägergenerators zumindest einem optischen Impuls (21; 36), wobei der oder jeder Impuls eine Dauer von weniger als 250 ps aufweist.

4. Verfahren nach Anspruch 3, wobei der antiferromagnetische Bereich (14; 31) auf dem Phototrägergenerator (12; 34) angeordnet ist.

5. Verfahren nach Anspruch 3 oder 4, wobei der optische Impuls (21; 36) eine Wellenlänge aufweist, die einer Bandlücke eines Halbleitermaterials in dem Photostromgenerator (12) entspricht.

6. Verfahren nach Anspruch 3, 4 oder 5, wobei der Phototrägergenerator (12) eine p-i-n-Diode umfasst, die mit einer ersten Elektrode (18) bereitgestellt ist, und der antiferromagnetische Bereich mit zumindest zwei zweiten Elektroden (19) bereitgestellt ist, wobei das Verfahren ferner Folgendes umfasst:
umgekehrtes Vorspannen der p-i-n-Diode zwischen der ersten Elektrode und zumindest zwei der zweiten Elektroden.

7. Verfahren nach Anspruch 3 oder 4, wobei der Phototrägergenerator (34) ein photoleitender Schalter ist, wie zum Beispiel ein Auston-Schalter.

8. Verfahren nach einem der Ansprüche 3 bis 7, wobei die Vorrichtung ferner eine Metallschicht umfasst, die auf dem antiferromagnetischen Bereich (12; 31) angeordnet ist.

9. Verfahren nach einem vorhergehenden Anspruch, wobei der antiferromagnetische Bereich (2; 12; 31) ein antiferromagnetisches Material umfasst, das Bulk-Inversionsasymmetrie aufweist.

10. Verfahren nach einem der Ansprüche 1 bis 9, wobei der antiferromagnetische Bereich (2; 12; 31) eine Legierung umfasst, die Mangan beinhaltet.

11. Verfahren, umfassend:
Programmieren eines Zustands des antiferromagnetischen Bereichs (2; 12; 31) unter Verwendung des Verfahrens nach einem vorhergehenden Anspruch; und
Lesen des Zustands des antiferromagnetischen Bereichs.

12. Verfahren nach Anspruch 11, wobei das Lesen des Zustands des antiferromagnetischen Bereichs (2; 12; 31) Folgendes umfasst:
Durchführen einer Anisotropie-Magnetwiderstandsmessung.

13. Verfahren nach Anspruch 11 oder 12, wobei das Lesen des Zustands des antiferromagnetischen Bereichs (2; 12; 31) Folgendes umfasst:
Messen der Spannungsreaktion bei doppelter Frequenz auf einen Sondenwechselstrom.

14. Verfahren nach Anspruch 11, wobei das Lesen des Zustands des antiferromagnetischen Bereichs (2; 12; 31) Folgendes umfasst:
Durchführen einer optischen Messung.

15. Einrichtung, umfassend:
ein Array von antiferromagnetischen Speichervorrichtungen (1₁, 1₂, 1₃), wobei jeder antiferromagnetische Speicher einen jeweiligen antiferromagnetischen Bereich (2; 12; 31) umfasst, wobei der antiferromagnetische Bereich aus einem antiferromagnetischen Material besteht, das Inversionsasymmetrie von Spin-Untergittern aufweist;
einen Laser (6; 397), der konfiguriert ist, um dem Array von antiferromagnetischen Speichervorrichtungen zumindest einen Impuls bereitzustellen;
eine Auswahlschaltung (399), die mit jeder antiferromagnetischen Speichervorrichtung verbunden und konfiguriert ist, um die antiferromagnetische Speichervorrichtung zu programmieren und zu lesen;
wobei der Laser und die Auswahlschaltung konfiguriert sind, um das Verfahren nach einem der Ansprüche 1 bis 14 durchzuführen.

## Revendications

1. Procédé comprenant :
la génération d'au moins une impulsion de courant dans une zone antiferromagnétique (2) d'un dispositif de mémoire antiferromagnétique (1₁), la zone antiferromagnétique étant constitué d'un matériau antiferromagnétique présentant une asymétrie d'inversion des sous-réseaux de spin ;
une partie de la ou de chaque impulsion de courant possédant une durée inférieure à 250 ps et une amplitude qui est suffisamment élevée de sorte qu'une intensité de champ électrique supérieure ou égale à 10⁵ V
cm⁻¹ soit générée dans la zone antiferromagnétique de façon à induire un champ spin-orbite décalé suffisamment fort pour commuter des moments magnétiques dans au moins une partie de la zone antiferromagnétique, ladite partie de la ou de chaque impulsion de courant entraînant la commutation des moments magnétiques, et ladite génération de la au moins une impulsion comprenant :
l'exposition de la zone antiferromagnétique à au moins une impulsion gigahertz ou térahertz (5) de rayonnement électromagnétique qui est polarisé elliptiquement ou linéairement.

2. Procédé selon la revendication 1, une composante de polarisation dominante étant colinéaire au vecteur de Néel de la zone antiferromagnétique (2) avant la commutation.

3. Procédé comprenant :
la génération d'au moins une impulsion de courant dans une zone antiferromagnétique (14 ; 31) d'un dispositif de mémoire antiferromagnétique (1₂, 1₃) qui est en contact électrique avec, ou fait partie d'un générateur de photoporteur (12 ; 34), la zone antiferromagnétique étant constitué d'un matériau antiferromagnétique présentant une asymétrie d'inversion des sous-réseaux de spin ;
ladite impulsion de courant possédant une durée inférieure à 250 ps et une amplitude qui est suffisamment élevée de sorte qu'une intensité de champ électrique supérieure ou égale à 10⁵ V cm⁻¹ soit générée dans
la zone antiferromagnétique de façon à induire un champ spin-orbite décalé suffisamment fort pour commuter des moments magnétiques dans au moins une partie de la zone antiferromagnétique, ladite génération de l'impulsion comprenant :
l'exposition du générateur de photoporteurs à au moins une impulsion optique (21 ; 36), la ou chaque impulsion possédant une durée inférieure à 250 ps.

4. Procédé selon la revendication 3, ladite zone antiferromagnétique (14 ; 31) étant disposée sur le générateur de photoporteur (12 ; 34).

5. Procédé selon la revendication 3 ou 4, ladite impulsion optique (21 ; 36) possédant une longueur d'onde correspondant à une bande interdite d'un matériau semi-conducteur dans le générateur de photocourant (12).

6. Procédé selon la revendication 3, 4 ou 5, ledit générateur de photoporteur (12) comprenant une diode pin dotée d'une première électrode (18) et ladite zone antiferromagnétique étant dotée d'au moins deux secondes électrodes (19), ledit procédé comprenant en outre :
la polarisation en inverse de la diode pin entre la première électrode et au moins deux des secondes électrodes.

7. Procédé selon la revendication 3 ou 4, ledit générateur de photoporteur (34) étant un commutateur photoconducteur, tel qu'un commutateur Auston.

8. Procédé selon l'une quelconque des revendications 3 à 7, ledit dispositif comprenant en outre une couche métallique disposée sur la zone antiferromagnétique (12 ; 31).

9. Procédé selon une quelconque revendication précédente, ladite zone antiferromagnétique (2 ; 12 ; 31) comprenant un matériau antiferromagnétique présentant une asymétrie d'inversion de masse.

10. Procédé selon l'une quelconque des revendications 1 à 9, ladite zone antiferromagnétique (2 ; 12 ; 31) comprenant un alliage qui comprend du manganèse.

11. Procédé comprenant :
la programmation d'un état de la zone antiferromagnétique (2 ; 12 ; 31) à l'aide du procédé d'une quelconque revendication précédente ; et
la lecture de l'état de la zone antiferromagnétique.

12. Procédé selon la revendication 11, ladite lecture de l'état de la zone antiferromagnétique (2 ; 12 ; 31) comprenant :
la réalisation d'une mesure de magnétorésistance d'anisotropie.

13. Procédé selon la revendication 11 ou 12, ladite lecture de l'état de la zone antiferromagnétique (2 ; 12 ; 31) comprenant :
la mesure de la réponse en tension à double fréquence à un courant de sonde alternatif.

14. Procédé selon la revendication 11, ladite lecture de l'état de la zone antiferromagnétique (2 ; 12 ; 31) comprenant :
la réalisation d'une mesure optique.

15. Appareil comprenant :
un réseau de dispositifs de mémoire antiferromagnétique (1₁, 1₂, 1₃), chaque mémoire antiferromagnétique comprenant une zone antiferromagnétique respective (2 ; 12 ; 31), la zone antiferromagnétique étant constitué d'un matériau antiferromagnétique présentant une asymétrie d'inversion de sous-réseaux de spin ;
un laser (6 ; 397) conçu pour fournir au moins une impulsion au réseau de dispositifs de mémoire antiferromagnétique ;
un circuit de sélection (399) connecté à chaque dispositif de mémoire antiferromagnétique et conçu pour programmer et lire le dispositif de mémoire antiferromagnétique ;
ledit laser et ledit circuit de sélection étant conçus pour réaliser le procédé selon l'une quelconque des revendications 1 à 14.
